# EUROPEAN PATENT SPECIFICATION

(11) **EP 4 557 355 B1**
(45) Date of publication and mention of the grant of the patent: **30.09.2026**
(21) Application number: 24190234.5
(22) Date of filing: 23.07.2024
(51) Int. Cl.: H10W 20/00, H10W 20/20, H10W 20/41, H10D 30/01, H10D 62/10, H10D 84/01, H10D 84/03, H10D 84/83, H10D 84/85, B82Y 10/00, H10D 30/00, H10D 62/13, H10D 64/23, H10W 20/46, H10W 20/47, H10W 20/40

(54) **SEMICONDUCTOR DEVICE AND METHOD OF MANUFACTURING SEMICONDUCTOR DEVICE**
HALBLEITERBAUELEMENT UND VERFAHREN ZUR HERSTELLUNG EINES HALBLEITERBAUELEMENTS
DISPOSITIF SEMI-CONDUCTEUR ET PROCÉDÉ DE FABRICATION DE DISPOSITIF SEMI-CONDUCTEUR

(30) Priority: 20.11.2023 KR 20230161321
(43) Date of publication of application: 21.05.2025
(73) Proprietor: SAMSUNG ELECTRONICS CO., LTD., Yeongtong-gu Suwon-si, Gyeonggi-do 16677 (KR)
(72) Inventor: KIM, YoungJun, 16677 Suwon-si, Gyeonggi-do (KR); PARK, Sangjine, 16677 Suwon-si, Gyeonggi-do (KR); LEE, Jinmyoung, 16677 Suwon-si, Gyeonggi-do (KR)
(74) Representative: Kuhnen & Wacker Patent- und Rechtsanwaltsbüro PartG mbB

(56) References cited:
- US-A1- 2022 157 722
- US-A1- 2022 359 516
- US-A1- 2024 162 152

## Description

### BACKGROUND

### 1. Field

The present disclosure relates generally to semiconductor devices, and more particularly, to semiconductor devices with a decreased parasitic capacitance and method of manufacturing the same.

### 2. Description of the Related Art

Semiconductor devices may be used in various electronic devices, such as, but not limited to, storage devices that may store data, and processors that may calculate and/or process data. With the development of the electronic industry, various methods for improving various characteristics such as, but not limited to, integration, reliability, speeds, and functions of the semiconductor devices may be researched. For example, semiconductor devices having a three-dimensional (3D) structure may have been proposed to potentially overcome limitations that may be caused by the size reduction of the semiconductor devices.

Recently, research may be conducted to potentially improve routing congestion and scale the size of semiconductor devices by placing a power delivery network on the back of the substrate to route signals provided to semiconductor devices.

US 2022/157722 A1 discloses a through electrode penetrating a gate separation pattern.

### SUMMARY

One or more example embodiments of the present disclosure provide a semiconductor device and a manufacturing method thereof capable of decreasing a parasitic capacitance that may exist between an active region and a power delivery network.

According to an aspect of the present disclosure, a semiconductor device includes a base insulation layer including a first surface and a second surface facing the first surface, a channel layer on the first surface of the base insulation layer, source/drain patterns disposed in a first direction parallel to the first surface of the base insulation layer interposing the channel layer, a gate structure extending in a second direction crossing the first direction on the first surface of the base insulation layer and at least partially surrounding the channel layer, a gate separation pattern crossing the gate structure and at least partially penetrating the gate structure in a third direction perpendicular to the first direction and the second direction, and a through electrode at least partially penetrating the gate separation pattern in the third direction. The gate structure includes a first gate structure disposed on a first side of the gate separation pattern and a second gate structure disposed on a second side of the gate separation pattern. The gate separation pattern includes an air gap disposed between the first gate structure and the through electrode and between the second gate structure and the through electrode.

According to an aspect of the present disclosure, a method of manufacturing a semiconductor device includes forming, on a first surface of a substrate, a channel layer and source/drain patterns disposed in a first direction parallel to the first surface of the substrate interposing the channel layer, forming a gate structure extending in a second direction crossing the first direction and at least partially surrounding the channel layer in the second direction, forming a gate separation pattern crossing the gate structure and at least partially penetrating the gate structure in a third direction perpendicular to the first direction and the second direction, forming a through electrode at least partially penetrating the gate separation pattern in the third direction, and forming an air gap between the gate structure and a first sidewall and a second sidewall of the through electrode within the gate separation pattern.

According to an aspect of the present disclosure, a semiconductor device includes a base insulation layer including a first surface and a second surface facing the first surface, a channel layer on the first surface of the base insulation layer, source/drain patterns disposed in a first direction parallel to the first surface of the base insulation layer interposing the channel layer, a gate structure extending in a second direction crossing the first direction on the first surface of the base insulation layer and at least partially surrounding the channel layer, a gate separation pattern crossing the gate structure and at least partially penetrating the gate structure in a third direction perpendicular to the first direction and the second direction, an interlayer insulation layer at least partially covering the source/drain patterns, the gate structure and the gate separation pattern, an upper wire structure on the interlayer insulation layer, a lower wire structure on the second surface of the base insulation layer, a power rail on the lower wire structure and at least partially penetrating the base insulation layer in the third direction, and a through electrode at least partially penetrating the gate separation pattern in the third direction and including a first end coupled to the power rail. The gate separation pattern includes an air gap.

Additional aspects may be set forth in part in the description which follows and, in part, may be apparent from the description, and/or may be learned by practice of the presented embodiments.

### BRIEF DESCRIPTION OF THE DRAWINGS

The above and other aspects, features, and advantages of certain embodiments of the present disclosure may be more apparent from the following description taken in conjunction with the accompanying drawings, in which:
FIG. 1 is a top plan view showing a semiconductor device, according to an embodiment;
FIG. 2 is a cross-sectional view of a semiconductor device taken along line I-I' of FIG. 1, according to an embodiment;
FIG. 3 is a cross-sectional view of a semiconductor device taken along line II-II' of FIG. 1, according to an embodiment;
FIG. 4 is a cross-sectional view of a semiconductor device taken along line III-III' of FIG. 1, according to an embodiment;
FIG. 5 is a cross-sectional view of a semiconductor device taken along line IV-IV' of FIG. 1, according to an embodiment;
FIG. 6 is a cross-sectional view of a semiconductor device according to an embodiment, according to an embodiment;
FIG. 7A and FIG. 7B are cross-sectional views of a semiconductor device, according to an embodiment;
FIGS. 8 to 37 are drawings illustrating a method of manufacturing a semiconductor device, according to an embodiment;
FIG. 38 is a top plan view showing a semiconductor device, according to an embodiment;
FIG. 39 is a cross-sectional view of a semiconductor device taken along line I-I' of FIG. 38, according to an embodiment;
FIG. 40 is a cross-sectional view of a semiconductor device taken along line II-II' of FIG. 38, according to an embodiment;
FIG. 41 is a cross-sectional view of a semiconductor device taken along line III-III' of FIG. 38, according to an embodiment; and
FIG. 42 is a cross-sectional view of a semiconductor device taken along line IV-IV' of FIG. 38, according to an embodiment;

### DETAILED DESCRIPTION

The present disclosure is described hereinafter with reference to the accompanying drawings, in which embodiments of the present disclosure are shown.

The drawings and description are to be regarded as illustrative in nature and not restrictive. Like reference numerals may designate like elements throughout the specification.

Size and thickness of each constituent element in the drawings may be arbitrarily illustrated for better understanding and ease of description, and thus, the following embodiments are not limited thereto. In the drawings, the thickness of layers, films, panels, regions, or the like, may be exaggerated for clarity and ease of description.

It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in any other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wired), wirelessly, or via a third element.

In addition, it is to be understood that when an element such as a layer, film, region, or substrate is referred to as being "above" or "on" another element, the element may be directly on the other element or intervening elements may also be present. In contrast, when an element is referred to as being "directly on" another element, there may be no intervening elements present. Further, when an element is referred to as being "above" or "on" a reference element, it may be located above or below the reference element, and it is not necessarily referred to as being located "above" or "on" in a direction opposite to gravity.

Further, unless explicitly described to the contrary, the word "comprise", and variations such as "comprises" or "comprising", is to be understood to imply the inclusion of stated elements but not the exclusion of any other elements.

Further, throughout the specification, the phrase "in a plan view" or "on a plane" may refer to viewing a target portion from the top, and the phrase "in a cross-sectional view" or "on a cross-section" may refer to viewing a cross-section formed by vertically cutting a target portion from the side.

The terms "upper," "middle", "lower", and the like may be replaced with terms, such as "first," "second," third" to be used to describe relative positions of elements. The terms "first," "second," third" may be used to describe various elements but the elements are not limited by the terms and a "first element" may be referred to as a "second element". Alternatively or additionally, the terms "first", "second", "third", and the like may be used to distinguish components from each other and do not limit the present disclosure. For example, the terms "first", "second", "third", and the like may not necessarily involve an order or a numerical meaning of any form.

As used herein, when an element or layer is referred to as "covering" another element or layer, the element or layer may cover at least a portion of the other element or layer, where the portion may include a fraction of the other element or may include an entirety of the other element. Similarly, when an element or layer is referred to as "penetrating" another element or layer, the element or layer may penetrate at least a portion of the other element or layer, where the portion may include a fraction of the other element or may include an entire dimension (e.g., length, width, depth) of the other element.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout this disclosure may, but do not necessarily, all refer to the same embodiment.

As used herein, each of the terms "AlO", "CoN", "HfO", "MoC", "MoN", "NbC", "NbN", "NiN", "PtN", "SiBN", "SiCₓN_{y}", "SiNₓ", "SiOBN", "SiOC", "SiOCN", "SiON", "SiOₓ", "TaAIN", "TaC", "TaCN", "TaN", "TaO", "TaSiN", "TaTiN", "TiAl", "TiAIC", "TiAIC-N", "TiAIN", "TiC", "TiN", "TiSiN", "WC", "WN", and the like may refer to a material made of elements included in each of the terms and is not a chemical formula representing a stoichiometric relationship.

In the accompanying drawings for a semiconductor device, as an illustrative example, gate-all-around (GAA) and multi-bridge channel field effect transistor (MBCFETTM) (including nanowires or nanosheets are shown, however, the present disclosure is not limited thereto. Depending on the embodiment, the semiconductor device may be and/or may include a fin-type field-effect transistor (FinFET) including a channel region of a fin pattern shape, a tunneling field-effect transistor (tunneling FET), a three-dimensional (3D) stack field-effect transistor (3D-SFET) structure, complementary field effect transistor (CFET) structure, or the like.

Hereinafter, a semiconductor device according to embodiments is described with reference to drawings.

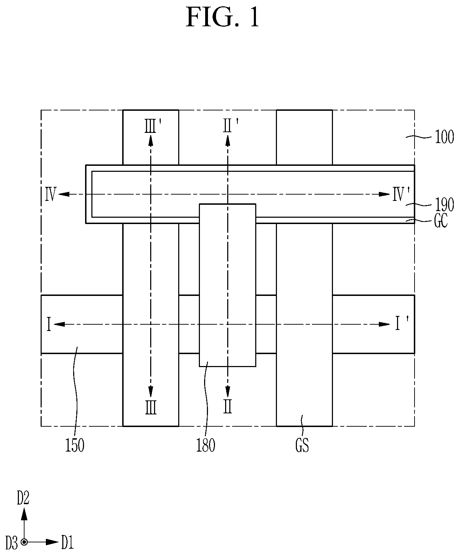

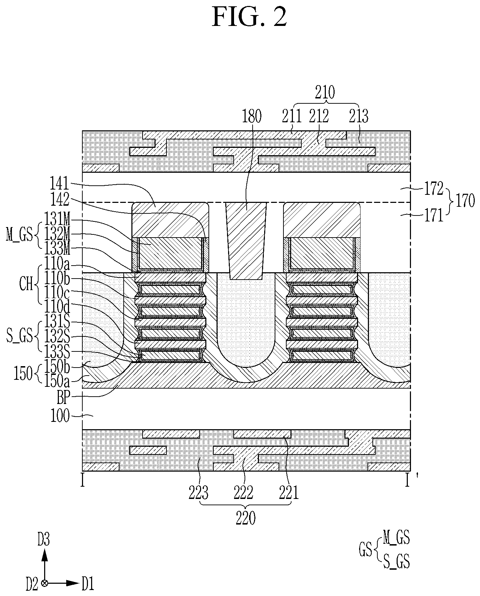

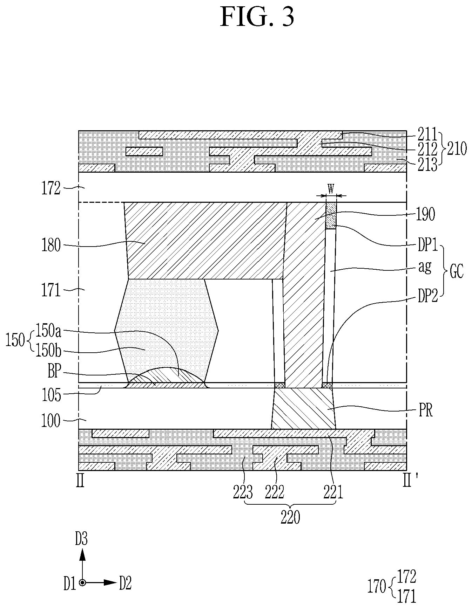

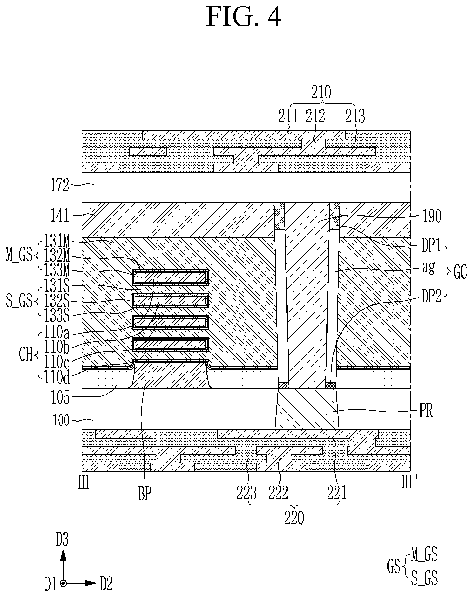

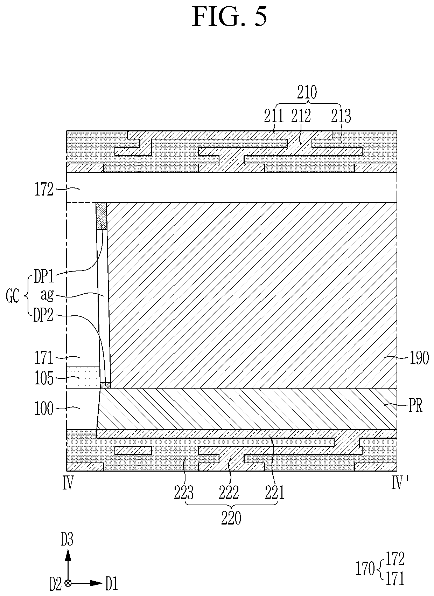

FIG. 1 is a top plan view showing a semiconductor device, according to an embodiment. FIGS. 2 to 4 are cross-sectional views showing a semiconductor device, according to an embodiment. FIG. 2 is a cross-sectional view of a semiconductor device taken along line I-I' of FIG. 1, according to an embodiment. FIG. 3 is a cross-sectional view of a semiconductor device taken along line II-II' of FIG. 1, according to an embodiment. FIG. 4 is a cross-sectional view of a semiconductor device taken along line III-III' of FIG. 1, according to an embodiment. FIG. 5 is a cross-sectional view of a semiconductor device taken along line IV-IV' of FIG. 1, according to an embodiment.

Referring to FIGS. 1 to 5, a semiconductor device, according to an embodiment, may include a base insulation layer 100, channel layers CH located on a first surface of the base insulation layer 100, source/drain patterns 150 located on both sides of the channel layers CH, gate structures GS (e.g., a main gate structure M_GS and a sub-gate structure S_GS) surrounding the channel layers CH, and a gate separation pattern GC crossing the gate structures GS (e.g., M_GS and S_GS).

The base insulation layer 100 may include an insulating material. The base insulation layer 100 may include, but not be limited to, a layer of oxide, nitride, nitride oxide, or a combination thereof. For example, the base insulation layer 100 may include silicon nitride (SiNₓ). Although the base insulation layer 100 is illustrated as a single layer, this is merely for the convenience of explanation, and the present disclosure is not limited thereto. The first surface and the second surface of the base insulation layer 100 may be formed as a plane parallel to a first direction D1 and a second direction D2 crossing the first direction D1. For example, the first surface of the base insulation layer 100 may be an upper surface, and the second surface may be a bottom surface. An upper surface of the base insulation layer 100 may be a surface opposite to a bottom surface of the base insulation layer 100 in a third direction D3. The third direction D3 may be a direction perpendicular to the first direction D1 and the second direction D2. The bottom surface of the base insulation layer 100 may be referred to as a backside of the base insulation layer 100. In some embodiments, a logic circuit in a cell region may be implemented on the upper surface of the base insulation layer 100.

The channel layers CH may be disposed on the base insulation layer 100. In an embodiment, a plurality of channel layers (e.g., a first channel layer 110a, a second channel layer 110b, a third channel layer 110c, and a fourth channel layer 110d) may be disposed on the base insulation layer 100. For example, each of the plurality of channel layers 110a to 110d may be and/or may include a semiconductor layer of a sheet shape. Each semiconductor layer may be and/or may include a nanosheet having a thickness of several nanometers (nm), for example, along the third direction D3.

The channel layers CH may provide a passage through which current may flow between two source/drain patterns 150. Referring to FIGS. 2 to 4, the first to fourth channel layers 110a to 110d may be disposed between the source/drain patterns 150, and connect source/drain patterns 150. The first to fourth channel layers 110a to 110d may penetrate a portion of the gate structure GS in a direction (e.g., the first direction D1) crossing the direction along which the gate structure GS extends. The first to fourth channel layers 110a to 110d may be arranged to be spaced apart from the upper surface of the base insulation layer 100 in a vertical direction (e.g., the third direction D3). Although FIGS. 2 and 4 illustrate four (4) channel layers 110a to 110d as being disposed to be spaced apart, the present disclosure is not limited thereto, and the number of stacked channel layers CH may be changed in various ways. The channel layers CH may include a semiconductor material. For example, the channel layers CH may include a group IV semiconductor such as, but not limited to, silicon (Si) and germanium (Ge), a group III-V compound semiconductor, a group II-VI compound semiconductor, or the like. In an embodiment, a lower pattern BP may be further disposed below the channel layers CH. For example, the lower pattern BP may be located between the base insulation layer 100 and a lowermost sub-gate structure S_GS from among a plurality of sub-gate structures S_GS. An upper surface of the lower pattern BP may contact a lower surface of the lowermost sub-gate structure S_GS from among the plurality of sub-gate structures S_GS. The lower pattern BP may include the same material as the channel layers CH. For example, the lower pattern BP may include a group IV semiconductor such as, but not limited to, silicon (Si) and germanium (Ge), a group III-V compound semiconductor, a group II-VI compound semiconductor, or the like. However, the present disclosure is not limited thereto, and the lower pattern BP may include a material different from the channel layers CH.

As another embodiment, the semiconductor device may not include the lower pattern BP. In such an embodiment, the lower surface of the lowermost sub-gate structure S_GS from among the plurality of sub-gate structures S_GS may directly contact the base insulation layer 100.

In an embodiment, a partial region of the base insulation layer 100 overlapping the sub-gate structure S_GS in the third direction D3 may extend into an interior of the lower pattern BP, and may directly contact the lower surface of the lowermost sub-gate structure S_GS from among the plurality of sub-gate structures S_GS. The lower pattern BP may be located in a lower portion of the source/drain pattern 150 located on both sides of the sub-gate structure S_GS, and the lower patterns BP located in the lower portions of different source/drain patterns 150 may be separated by the base insulation layer 100. The base insulation layer 100 may be located between the lower patterns BP located in the lower portions of the different source/drain patterns 150.

A semiconductor device, according to an embodiment, may further include a field insulation layer 105. The field insulation layer 105 may be located on the lower pattern BP. The field insulation layer 105 may be located on a sidewall of the lower pattern BP. The field insulation layer 105 may not be located on the upper surface of the lower pattern BP. The field insulation layer 105 may entirely cover a side surface of the lower pattern BP. In an embodiment, the field insulation layer 105 may cover a portion of the sidewall of the lower pattern BP. In such an embodiment, a portion of the lower pattern BP may protrude from an upper surface of the field insulation layer 105 in the third direction D3. The field insulation layer 105 may include, for example, a layer of oxide, nitride, nitride oxide, or a combination thereof. Although the field insulation layer 105 is illustrated as a single layer, this is merely for the convenience of explanation, and the present disclosure is not limited thereto.

The source/drain pattern 150 may be located on the base insulation layer 100. The lower pattern BP may be located between the source/drain pattern 150 and the base insulation layer 100. However, the present disclosure is not limited thereto, and the lower pattern BP may not be located between the source/drain pattern 150 and the base insulation layer 100. The source/drain pattern 150 may be located on both sides of the channel layers CH or the sub-gate structure S_GS. That is, the two source/drain patterns 150 may be arranged in a direction (e.g., the first direction D1) crossing the direction along which the gate structure GS extends, interposing the channel layers CH or the sub-gate structure S_GS. The source/drain pattern 150 may directly contact the channel layers CH or the sub-gate structure S_GS. The source/drain pattern 150 may directly contact a sub-interface insulation layer 133S of the sub-gate structure S_GS. In an embodiment, an inner spacer may be further disposed between the source/drain pattern 150 and the sub-interface insulation layer 133S. The inner spacer may include, but not be limited to, at least one of silicon nitride (SiNₓ), silicon nitride oxide (SiON), silicon oxide (SiOₓ), silicon carbonate nitride (SiOCN), silicon boronnitride (SiBN), silicon oxyboronitride (SiOBN), silicon oxycarbide (SiOC), a combination thereof, or the like.

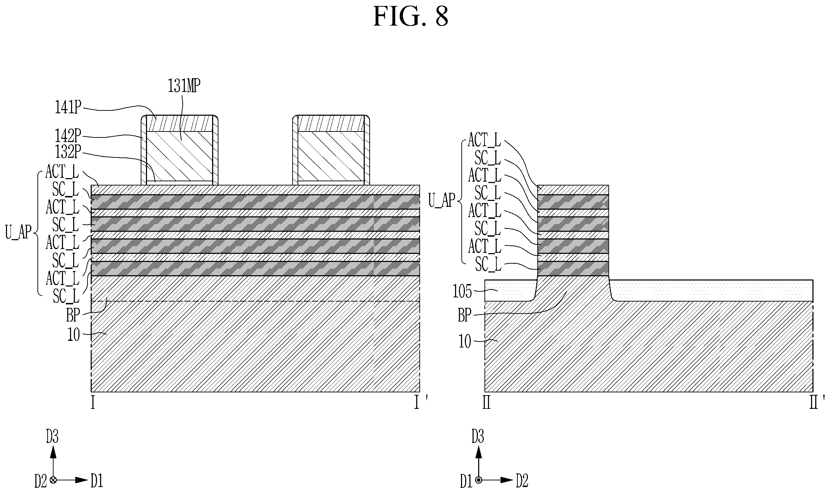

The source/drain pattern 150 may be formed as an epitaxial layer formed by selective epitaxial growth (SEG), in a region where a portion of a sacrificial pattern (e.g., a sacrificial pattern SC_L of FIG. 8) and an active pattern (e.g., an active pattern ACT_L of FIG. 8) may be recessed. That is, the source/drain patterns 150 may fill the region where a portion of the sacrificial pattern SC_L and the active pattern ACT_L may be recessed.

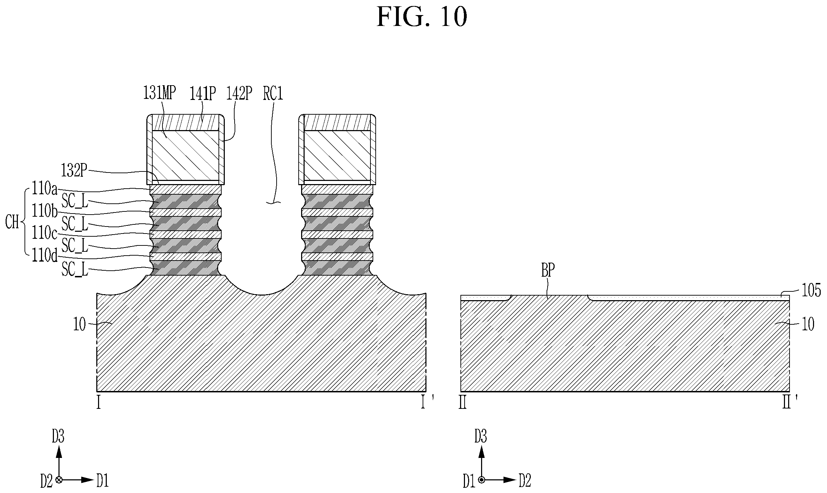

The source/drain patterns 150 may include a liner layer 150a and a filling layer 150b, respectively. The liner layer 150a may be located on side surfaces and bottom surface of the source/drain pattern 150. The liner layer 150a may directly contact the sub-gate structure S_GS and the channel layers CH. That is, the liner layers 150a may be located along a surface profile of a source/drain recess (e.g., a source/drain recess RC1 of FIG. 10). The filling layer 150b may be located on the liner layer 150a. The filling layer 150b and the liner layer 150a may have upper surfaces of a substantially similar and/or the same height. That is, the filling layer 150b may fill an interior of the source/drain recess RC1.

The source/drain pattern 150 may include a semiconductor material. The source/drain pattern 150 may include, for example, silicon (Si) or germanium (Ge). In addition, the source/drain pattern 150 may include, for example, a binary compound, or a ternary compound including at least two or more of carbon (C), silicon (Si), germanium (Ge), or tin (Sn). For example, the source/drain pattern 150 may include silicon (Si), silicon-germanium (Si-Ge), germanium (Ge), silicon carbide (SiC), or the like. However, the present disclosure is not limited thereto. In an embodiment, the liner layer 150a and the filling layer 150b may have different concentrations of silicon (Si), or germanium (Ge). For example, the concentration of silicon (Si) or germanium (Ge) included in the liner layers 150a may be smaller than the concentration of silicon (Si) or germanium (Ge) included in the filling layer 150b.

In an embodiment, the source/drain pattern 150 may be electrically connected to a lower wire structure 220 through a power rail PR and a contact electrode 180. The source/drain pattern 150 may receive electric power from the lower wire structure 220 through the power rail PR and the contact electrode 180.

The gate structure GS may be disposed on the base insulation layer 100. The lower pattern BP or the field insulation layer 105 may be located between the gate structure GS and the base insulation layer 100. The gate structure GS may include the sub-gate structure S_GS and the main gate structure M_GS. The sub-gate structure S_GS may be disposed on the base insulation layer 100, and the main gate structure M_GS may be disposed on the sub-gate structure S_GS. On the base insulation layer 100, the gate structure GS may extend in a different direction other than the direction along which the source/drain patterns 150 are arranged. For example, on the base insulation layer 100, the gate structure GS may extend in a direction (e.g., the second direction D2) crossing the direction along which the source/drain patterns 150 are arranged. The gate structure GS may be located on the base insulation layer 100. The gate structures GS may be arranged to be spaced apart in the first direction D1. The main gate structure M_GS may be located on an uppermost channel layer 110a. The main gate structure M_GS may also be located on a side surface of the structure in which the first to fourth channel layers 110a to 110d and the sub-gate structures S_GS are stacked. That is, the main gate structure M_GS may surround each of the channel layers 110a to 110d together with the sub-gate structures S_GS. However, the main gate structure M_GS may not be located on a surface where each of the channel layers 110a to 110d contacts the source/drain pattern 150. Although FIGS. 2 and 4 illustrates four (4) sub-gate structures S_GS arranged in the third direction, the number of the arranged sub-gate structures S_GS is not limited thereto. For example, the gate structure GS may include three (3) sub-gate structures S_GS.

The sub-gate structures S_GS may contact the source/drain pattern 150. For example, the sub-gate structure S_GS may directly contact the source/drain pattern 150. The sub-gate structures S_GS may be located on both sides of the source/drain pattern 150. Each of the sub-gate structures S_GS may be formed in multiple layers. For example, each of the sub-gate structures S_GS may include a sub-gate electrode 131S, a sub-gate insulation layer 132S and the sub-interface insulation layer 133S. The sub-gate structures S_GS and the first to fourth channel layers 110a to 110d may be alternately stacked in the third direction D3. The sub-gate structures S_GS may surround surfaces of the first to fourth channel layers 110a to 110d other than surfaces connected to the source/drain pattern 150, together with the main gate structure M_GS.

The sub-gate electrode 131S may include, but not be limited to, at least one of a metal, a metal alloy, a conductive metal nitride, a metal silicide, a doped semiconductor material, a conductive metal oxide, a conductive metal nitride oxide, or the like. The sub-gate electrode 131S may include, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), Zinc (Zn), vanadium (V), and a combination thereof, however, the present disclosure is not limited thereto. The conductive metal oxide and the conductive metal nitride oxide may include oxidized forms of the above-mentioned materials, however, the present disclosure is not limited thereto.

The sub-interface insulation layer 133S may be located along a circumference of the channel layers CH. For example, the sub-interface insulation layer 133S may surround surfaces of the channel layers CH other than the surface connected to the source/drain pattern 150. The sub-interface insulation layer 133S may directly contact the source/drain pattern 150 and the channel layers CH. The sub-interface insulation layer 133S may be interposed between the channel layers CH and the sub-gate insulation layer 132S. The sub-interface insulation layer 133S may include, for example, silicon oxide (SiOₓ).

The sub-gate insulation layer 132S may extend along an upper surface of the sub-interface insulation layer 133S. The sub-gate insulation layer 132S may surround the channel layers CH. For example, the sub-gate insulation layer 132S may surround surfaces of the channel layers CH other than the surface connected to the source/drain pattern 150. The sub-gate insulation layer 132S may be located along the circumference of the channel layers CH. The sub-gate insulation layer 132S may be interposed between the sub-gate electrode 131S and the sub-interface insulation layer 133S. The sub-gate insulation layer 132S may include, for example, a high dielectric constant material. The high dielectric constant material may include a material having a higher dielectric constant than silicon oxide (SiOₓ) such as, but not limited to, hafnium oxide (HfO), aluminum oxide (AlO), tantalum oxide (TaO), or the like.

The main gate structure M_GS may be located on the sub-gate structure S_GS and the channel layers CH. The main gate structure M_GS may be located on an upper surface of the channel layers CH. Each of the main gate structures M_GS may be formed in multiple layers. For example, the main gate structure M_GS may include a main gate electrode 131M, a main interface insulation layer 133M, and a main gate insulation layer 132M. The main gate structure M_GS may surround surfaces of at least one (e.g., the first channel layer 110a) of the channel layers CH other than the surface connected to the source/drain pattern 150, together with the sub-gate structure S_GS.

The main gate electrode 131M may be located on the sub-gate structure S_GS and the channel layers CH. The main gate electrode 131M may be located on the upper surface of the channel layers CH. The main gate electrode 131M may include the same material as the sub-gate electrode 131S. For example, the main gate electrode 131M may include, but not be limited to, at least one of a metal, a metal alloy, a conductive metal nitride, a metal silicide, a doped semiconductor material, a conductive metal oxide, a conductive metal nitride oxide, or the like.

The main interface insulation layer 133M may extend along the upper surface of the channel layers CH. The main interface insulation layer 133M may include, for example, silicon oxide (SiOₓ). The main gate insulation layer 132M may extend along the side surface and the bottom surface of the main gate electrode 131M. The main gate insulation layer 132M may include, for example, a high dielectric constant material.

In an embodiment, the gate structure GS may be electrically separated from adjacent gate structures by the gate separation pattern GC. That is, referring to FIGS. 1 and 4, a partial region of the main gate structure M_GS may be penetrated in the third direction D3 by the gate separation pattern GC, and accordingly, the main gate structure M_GS may be electrically separated from adjacent gate structures in the second direction D2.

A semiconductor device, according to an embodiment, may further include a capping layer 141 and a gate spacer 142. The gate spacer 142 may be located on a side surface of the main gate electrode 131M. The gate spacer 142 may not be disposed between the lower pattern BP and the channel layers CH. The gate spacer 142 may not be disposed between the channel layers CH adjacent in the third direction D3. Although the gate spacer 142 is illustrated as a single layer, this is merely for the convenience of explanation, and the present disclosure is not limited thereto. The gate spacer 142 may include, for example, at least one of silicon nitride (SiNₓ), silicon nitride oxide (SiON), silicon oxide (SiOₓ), silicon carbonate nitride (SiOCN), silicon boronnitride (SiBN), silicon oxyboronitride (SiOBN), silicon oxycarbide (SiOC), a combination thereof, or the like.

The capping layer 141 may be located on the main gate structure M_GS and the gate spacer 142. In an embodiment, the capping layer 141 may be located between the gate spacers 142. The capping layer 141 may include, for example, at least one of silicon nitride (SiNₓ), silicon nitride oxide (SiON), silicon (Si) carbonitride (SiCN), silicon carbonate nitride (SiOCN), a combination thereof, or the like. The capping layer 141 may include a material having etch selectivity with respect to an interlayer insulation layer 170.

In an embodiment, the capping layer 141 and the gate spacer 142 may be penetrated in the third direction D3 along the gate separation pattern GC by a through electrode 190. The capping layer 141 may have an upper surface having a substantially similar and/or the same height as an upper surface of the gate separation pattern GC.

The gate separation pattern GC may extend in a direction (e.g., the first direction D1) crossing the gate structure GS. The gate separation pattern GC may also extend in the third direction D3. That is, the gate separation pattern GC may extend in the third direction D3, and penetrate the main gate structure M_GS. Accordingly, the gate separation pattern GC may electrically separate gate structures arranged in the first direction D1. The gate separation pattern GC may have an upper surface having a substantially similar and/or the same height as the capping layer 141 and/or the contact electrode 180. The gate separation pattern GC may penetrate the main gate structure M_GS in third direction, and extend into the field insulation layer 105. Referring to FIGS. 3 to 5, a lower surface of the gate separation pattern GC may contact an upper surface of the power rail PR. The gate separation pattern GC may include an insulating material. For example, the gate separation pattern GC may include silicon nitride (SiNₓ), silicon oxide (SiOₓ), and/or silicon carbonitride (SiCₓN_{y}). However, the present disclosure is not limited thereto, and the gate separation pattern GC may include various insulating materials for electrically separating the main gate structure M_GS from other gate structures. In an embodiment, the gate separation pattern GC may be penetrated in the third direction D3 by the through electrode 190. That is, the gate separation pattern GC may surround a sidewall of the through electrode 190. Accordingly, the gate separation pattern GC may contact the sidewall of the through electrode 190. The gate separation pattern GC may have an upper surface having a substantially similar and/or the same height as an upper surface of the through electrode 190. The gate separation pattern GC may have a lower surface having a substantially similar and/or the same height as a lower surface of the through electrode 190.

Referring to FIGS. 3 to 5, the gate separation pattern GC may include a plurality of insulation patterns (e.g., a first insulation pattern DP1 and a second insulation pattern DP2), and an air gap ag located between the first and second insulation patterns DP1 and DP2. For example, the gate separation pattern GC may include the first insulation pattern DP1, the second insulation pattern DP2, and the air gap ag located between the first insulation pattern DP1 and the second insulation pattern DP2. The air gap ag may refer to an empty space located between one layer and another layer. For example, the air gap ag may include air and/or a gas used in the semiconductor device manufacturing process.

An upper surface of the first insulation pattern DP1 may contact a second interlayer insulation layer 172. A side surface of the first insulation pattern DP1 may contact the capping layer 141 and/or a first interlayer insulation layer 171. The first insulation pattern DP1 may not be located in a region where the gate separation pattern GC is penetrated by the contact electrode 180. Referring to FIG. 3, the first insulation pattern DP1 may have a lower surface located at a level higher than or equal to that of an upper surface of the source/drain pattern 150. That is, the first insulation pattern DP1 may not overlap the source/drain pattern 150 in the second direction D2. The first insulation pattern DP1 may include an insulating material. For example, the first insulation pattern DP1 may include at least one insulating material of silicon nitride (SiNₓ), silicon oxide (SiOₓ) and/or silicon carbonitride (SiCₓN_{y}). However, the present disclosure is not limited thereto, and the first insulation pattern DP1 may include various insulating materials for electrically separating the main gate structure M_GS from other gate structures. In an embodiment, the first insulation pattern DP1 may include an insulating material different from the insulating material included in the interlayer insulation layer 170. The first insulation pattern DP1 may include an insulating material having etch selectivity with respect to the interlayer insulation layer 170.

A lower surface of the second insulation pattern DP2 may contact the power rail PR. A side surface of the second insulation pattern DP2 may contact the field insulation layer 105. Referring to FIG. 3, the second insulation pattern DP2 may have an upper surface located at a level lower than or equal to that of a lower surface of the source/drain pattern 150. That is, the second insulation pattern DP2 may not overlap the source/drain pattern 150 in the second direction D2. However, the present disclosure is not limited thereto, and the second insulation pattern DP2 may have an upper surface located at a higher level than the lower surface of the source/drain pattern 150. The second insulation pattern DP2 may include an insulating material. For example, the second insulation pattern DP2 may include at least one insulating material of silicon nitride (SiNₓ), silicon oxide (SiOₓ), and/or silicon carbonitride (SiCₓN_{y}). However, the present disclosure is not limited thereto, and the second insulation pattern DP2 may include various insulating materials for electrically separating the main gate structure M_GS from other gate structures. In an embodiment, the second insulation pattern DP2 may include the same insulating material as the insulating material included in the base insulation layer 100. In an embodiment, the second insulation pattern DP2 may be formed in the same process as the base insulation layer 100. However, the present disclosure is not limited thereto, and the second insulation pattern DP2 may be formed in a process separate from a process in which the base insulation layer 100 is formed. In such an embodiment, the second insulation pattern DP2 may include an insulating material different from the insulating material included in the base insulation layer 100.

The air gap ag may be located between the first insulation pattern DP1 and the second insulation pattern DP2. The air gap ag may refer to an empty space located between the first insulation pattern DP1 and the second insulation pattern DP2. Referring to FIG. 3, the air gap ag may include a portion that may overlap the source/drain pattern 150 in the second direction D2. In an embodiment, the dielectric constant of the air gap ag may be lower than the dielectric constant of an insulating material included in the first insulation pattern DP1 and/or the second insulation pattern DP2. In an embodiment, the air gap ag may be filled with air, and the dielectric constant of air may be about 1.

In an embodiment, the width w of the gate separation pattern GC may be less than or equal to about 10 nm. In an embodiment, the width w of the gate separation pattern GC may be greater than or equal to about 2 nm, and may be smaller than or equal to about 8 nm. In another embodiment, the width w of the gate separation pattern GC may be greater than or equal to about 4 nm, and may be smaller than or equal to about 6 nm. However, the width w of the gate separation pattern GC is not limited thereto, and may be greater than or equal to about 10 nm in some cases.

A semiconductor device, according to an embodiment, may further include the through electrode 190 penetrating the gate separation pattern GC, the contact electrode 180 located between the source/drain pattern 150 and the through electrode 190, the interlayer insulation layer 170 covering the source/drain pattern 150, the gate structure GS, and the gate separation pattern GC, an upper wire structure 210 located on the interlayer insulation layer 170, the lower wire structure 220 located on a lower surface of the base insulation layer 100, and the power rail PR located on the lower wire structure 220.

The through electrode 190 may interconnect the contact electrode 180 and the power rail PR. That is, a portion of the through electrode 190 may contact the contact electrode 180, and another portion may contact the power rail PR. Referring to FIGS. 1 to 5, the through electrode 190, according to an embodiment, may be located inside the gate separation pattern GC. That is, the through electrode 190 may be surround by the gate separation pattern GC. Accordingly, the contact electrode 180 may penetrate a partial region of the gate separation pattern GC, and be connected to the through electrode 190. A width of the through electrode 190 in the second direction D2 may be narrower (e.g., decrease) as it is closer to the power rail PR. The through electrode 190 may penetrate the gate separation pattern GC in the third direction D3. Accordingly, both sidewalls of the through electrode 190 may contact the gate separation pattern GC. The air gap ag may be located between the gate structure GS and portions of both sidewalls of the through electrode 190. Accordingly, the gate structure GS comprises a first gate structure disposed on a first side of the gate separation pattern GC and a second gate structure disposed on a second side of the gate separation pattern GC. The air gap ag may be disposed between the first gate structure and the through electrode 190 and between the second gate structure and the through electrode 190. The air gap ag may be located between the first interlayer insulation layer 171 and both sidewalls of the through electrode 190. The through electrode 190 may have an upper surface having a substantially similar and/or the same height as the gate separation pattern GC. The through electrode 190 may extend in the first direction D1 that is parallel to the gate separation pattern GC and the gate structure GS. The through electrode 190 may include a conductive material. For example, the through electrode 190 may include at least one of metal, metal alloy, conductive metal nitride, conductive metal carbide, conductive metal oxide, a conductive metal carbonitride, or the like. As the through electrode 190 is located inside the gate separation pattern GC, when manufacturing a semiconductor device, according to an embodiment, the process margin may be improved, and the short circuit that may occur between the source/drain pattern 150 and the through electrode 190 may potentially be prevented.

The contact electrode 180 may interconnect the source/drain pattern 150 and the through electrode 190. That is, a portion of the contact electrode 180 may contact the source/drain pattern 150, and another portion may contact the through electrode 190. The contact electrode 180 may have an upper surface having a substantially similar and/or the same height as the through electrode 190 and the gate separation pattern GC. Referring to FIG. 3, a lower surface of the contact electrode 180 is shown to be at a substantially similar and/or the same height as an upper surface of the filling layer 150b. However, the present disclosure is not limited in this regard, and in another embodiment, the lower surface of the contact electrode 180 may include a partial region having a different height from the upper surface of the filling layer 150b. For example, a region overlapping the first interlayer insulation layer 171 in the third direction D3 among an entire region of the lower surface of the contact electrode 180 may have a lower height than the upper surface of the filling layer 150b.

Referring to FIGS. 1 and 3, the contact electrode 180 may extend in the second direction D2. In an embodiment, the contact electrode 180 may extend into the gate separation pattern GC. The contact electrode 180 may penetrate a partial region of the gate separation pattern GC, and be connected to a portion of the through electrode 190.

The contact electrode 180 may include a conductive material. For example, the contact electrode 180 may include at least one of a metal, a metal alloy, a conductive metal nitride, a conductive metal carbide, a conductive metal oxide, a conductive metal carbonitride, and a 2-dimensional (2D) material. The metal may include, titanium (Ti), at least one of tantalum (Ta), tungsten (W), nickel (Ni), cobalt (Co) and platinum (Pt). The conductive metal nitride may include at least one of titanium nitride (TiN), tantalum nitride (TaN), tungsten nitride (WN), nickel nitride (NiN), cobalt nitride (CoN) and platinum nitride (PtN).

The power rail PR may be located on the lower wire structure 220. The power rail PR may extend into the base insulation layer 100 along the third direction D3. That is, referring to FIGS. 3 and 4, the power rail PR may extend into the base insulation layer 100 along the third direction D3, and may contact the lower surface of the through electrode 190 and the gate separation pattern GC. The width of the power rail PR in the second direction D2 may become narrower as it becomes closer to the lower surface of the through electrode 190 and the gate separation pattern GC along the third direction D3. Referring to FIG. 5, the power rail PR may also extend in the first direction D1. A lower surface of the power rail PR may contact the lower wire structure 220. The power rail PR may include a conductive material. For example, the power rail PR may include at least one of metal, metal alloy, conductive metal nitride, conductive metal carbide, conductive metal oxide, conductive metal carbonitride, or the like. The power rail PR may be connected to the lower wire structure 220, and may transfer the electric power supplied from the lower wire structure 220 to the source/drain pattern 150.

The lower wire structure 220 may be disposed on the bottom surface of the base insulation layer 100. In an embodiment, the lower wire structure 220 may be and/or may include a component for supplying electrical power to at least one of the source/drain patterns 150. For example, the lower wire structure 220 may be and/or may include a power delivery network. The lower wire structure 220 may include lower wires 221, a lower via(s) 222 and a lower insulation layer 223. The lower wires 221 and the lower vias 222 may be located on the bottom surface of the base insulation layer 100. The lower wires 221 and the lower vias 222 may include a metal (e.g., copper (Cu)). The lower insulation layer 223 may be located on the bottom surface of the base insulation layer 100. The lower insulation layer 223 may be disposed between the bottom surface of the base insulation layer 100, the lower wires 221 and the lower vias 222 and insulate them. That is, the lower insulation layer 223 may cover the lower wires 221 and the bottom surface of the base insulation layer 100. A lower wire 221 and the lower vias 222 may be located within the lower insulation layer 223. The lower insulation layer 223 may include, for example, at least one of silicon oxide (SiOₓ), silicon nitride (SiNₓ), silicon nitride oxide (SiON), or low dielectric layers.

The interlayer insulation layer 170 may include the first interlayer insulation layer 171 and the second interlayer insulation layer 172. The interlayer insulation layer 170 may cover the source/drain pattern 150, the gate structure GS, the contact electrode 180, and the gate separation pattern GC. That is, the first interlayer insulation layer 171 may cover an upper surface and side surface of the source/drain pattern 150, a side surface of the gate separation pattern GC, a side surface of the contact electrode 180 and a side surface of the gate structure GS. The second interlayer insulation layer 172 may cover the first interlayer insulation layer 171, the upper surface of the gate separation pattern GC, an upper surface of the contact electrode 180 and an upper surface of the capping layer 141. The interlayer insulation layer 170 may include, for example, at least one of silicon oxide (SiOₓ), silicon nitride (SiNₓ), silicon nitride oxide (SiON), and a low dielectric constant material. Low dielectric constant material may include, for example, Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), Tonen SilaZen (TOSZ), fluoride silicate glass (FSG), polyimide nanofoams such as polypropylene oxide, carbon-doped silicon oxide (CDO), organo-silicate glass (OSG), SiLK, Amorphous Fluorinated Carbon, silica aerogels, silica xerogels, mesoporous silica or a combination thereof, but the present disclosure is not limited thereto. The first interlayer insulation layer 171 and the second interlayer insulation layer 172 may include a different material, or may include the same material. When the first interlayer insulation layer 171 and the second interlayer insulation layer 172 include the same material, a boundary between the first interlayer insulation layer 171 and the second interlayer insulation layer 172 may not be visible. In an embodiment, the interlayer insulation layer 170 may include a different material from the base insulation layer 100.

The upper wire structure 210 may be located on the interlayer insulation layer 170. The upper wire structure 210 may include upper wires 211, an upper via(s) 212 and an upper insulation layer 213. The upper wires 211 and the upper vias 212 may include a metal (e.g., copper (Cu)). The upper insulation layer 213 may be disposed between the upper wires 211 and the upper vias 212 and insulate them. The upper insulation layer 213 may cover the interlayer insulation layer 170 and the upper wires 211. The upper wires 211 and the upper vias 212 may be located within the upper insulation layer 213. The upper insulation layer 213 may include, for example, at least one of silicon oxide (SiOₓ), silicon nitride (SiNₓ), silicon nitride oxide (SiON), or low dielectric layers. The upper wire structure 210 may be electrically connected to at least one of the main gate electrode 131M and the source/drain pattern 150.

In a structure in which the through electrode 190 is located within the gate separation pattern GC, a parasitic capacitance may exist between the source/drain pattern 150 and the through electrode 190. As described with reference to FIGS. 1 to 5, in the region of the gate separation pattern GC overlapping the source/drain pattern 150 in the second direction D2, the air gap ag having a dielectric constant lower than a dielectric constant of an insulating material included in the first insulation pattern DP1 and/or the second insulation pattern DP2 may be located. In such an embodiment, in comparison with the case in which the gate separation pattern GC is entirely filled with the first insulation pattern DP1 and/or the second insulation pattern DP2, the parasitic capacitance between the source/drain pattern 150 and the through electrode 190 may be lowered, and accordingly, a performance degradation of a semiconductor device due to the parasitic capacitance may potentially be improved.

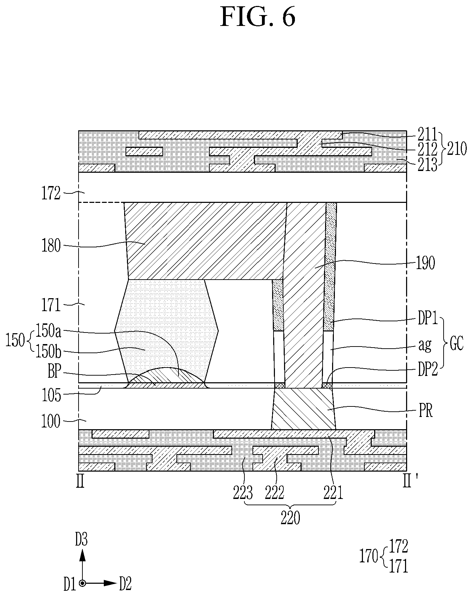

FIG. 6 is a cross-sectional view of a semiconductor device, according to an embodiment. Referring to FIG. 6, a cross-sectional view of a semiconductor device taken along line II-II' of FIG. 1 is illustrated. The semiconductor device shown in FIG. 6 may include and/or may be similar in many respects to the semiconductor device described above with reference to FIGS. 1 to 5, and may include additional features not mentioned above. Consequently, repeated descriptions of the semiconductor device described above with reference to FIGS. 1 to 5 may be omitted for the sake of brevity. In addition, the following description may focus on the difference of the semiconductor device disclosed in FIG. 6 compared to the semiconductor devices disclosed in FIGS. 1 to 5.

As shown in FIG. 6, the first insulation pattern DP1 may have a lower surface located at a level lower than or equal to that of the upper surface of the source/drain pattern 150. In addition, the first insulation pattern DP1 may have a lower surface located at a higher level than the lower surface of the source/drain pattern 150. That is, in an embodiment, the first insulation pattern DP1 may overlap a partial region of the source/drain pattern 150 in the second direction D2.

In an embodiment, the first insulation pattern DP1 may also be located below the contact electrode 180. The first insulation pattern DP1 may be further located between the contact electrode 180 and the air gap ag. A lower surface of the first insulation pattern DP1 may be located at a level lower than or equal to that of the upper surface of the source/drain pattern 150. In addition, the lower surface of the first insulation pattern DP1 may be located at a higher level than the lower surface of the source/drain pattern 150.

As shown in FIG. 6, the region in which the air gap ag is included within the gate separation pattern GC may be smaller compared to the semiconductor device described with reference to FIGS. 1 to 5. Accordingly, in the case of the semiconductor device disclosed in FIG. 6, the parasitic capacitance between the source/drain pattern 150 and the through electrode 190 may be maintained to be low, and at the same time, the structure may be more stable compared to the semiconductor device described with reference to FIGS. 1 to 5. That is, as shown in FIG. 6, the first insulation pattern DP1 may be further filled up to the region overlapping the source/drain pattern 150 in the second direction, and accordingly, the structure may be more robust compared to the semiconductor device described with reference to FIGS. 1 to FIG. 5. Among the configurations shown in FIG. 6, regarding other configurations excluding the gate separation pattern GC, the detailed configuration and connection relationship may be substantially similar and/or the same as the semiconductor device described with reference to FIGS. 1 to 5, and consequently, a detailed description thereof may be omitted for the sake of brevity.

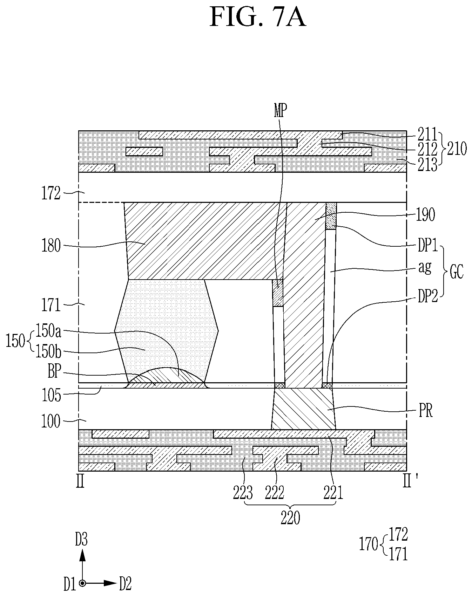

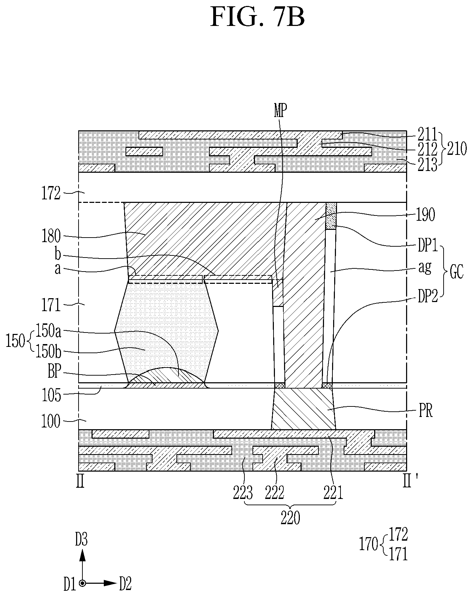

FIGS. 7A and 7B are cross-sectional views of a semiconductor device, according to an embodiment. Referring to FIGS. 7A and 7B, cross-sectional views of a semiconductor device taken along line II-II' of FIG. 1 are illustrated. The semiconductor devices shown in FIGS. 7A and 7B may include and/or may be similar in many respects to the semiconductor device described above with reference to FIGS. 1 to 5, and may include additional features not mentioned above. Consequently, repeated descriptions of elements of the semiconductor devices described above with reference to FIGS. 1 to 5 may be omitted for the sake of brevity. In addition, the following description may focus on the differences of the semiconductor devices disclosed in FIGS. 7A and 7B compared to the semiconductor devices disclosed in FIGS. 1 to 5.

Referring to FIGS. 7A and 7B, a semiconductor device may further include a metal pattern MP.

The metal pattern MP may be located in a region adjacent to the region where the gate separation pattern GC is penetrated by the contact electrode 180. That is, within the gate separation pattern GC, the metal pattern MP may be located in a portion of the region overlapping the contact electrode 180 in the third direction D3. Referring to FIG. 7A, an upper surface of the metal pattern MP may contact the lower surface of the contact electrode 180. The air gap ag may be located between a lower surface of the metal pattern MP and the second insulation pattern DP2. One aspect of the metal pattern MP may contact the through electrode 190.

The metal pattern MP may include a conductive material. In an embodiment, the metal pattern MP may include the contact electrode 180 and the same or different material. For example, the metal pattern MP may include at least one of metal, metal alloy, conductive metal nitride, conductive metal carbide, conductive metal oxide, conductive metal carbonitride and 2-dimensional (2D) material. The metal may include, titanium (Ti), at least one of tantalum (Ta), tungsten

(W), nickel (Ni), cobalt (Co) and platinum (Pt). The conductive metal nitride may include at least one of titanium nitride (TiN), tantalum nitride (TaN), tungsten nitride (WN), nickel nitride (NiN), cobalt nitride (CoN) and platinum nitride (PtN).

In FIG. 7A, the metal pattern MP is shown to be separate from the contact electrode 180, but as shown in FIG. 7B, the metal pattern MP may be a portion of the contact electrode 180. That is, the metal pattern MP may be formed together in the process of forming the contact electrode 180. In such an embodiment, the metal pattern MP may include the same material as the contact electrode 180.

In an embodiment, the lower surface of the contact electrode 180 and the lower surface of the metal pattern MP may have various heights. Referring to FIG. 7B, among an entire region of the lower surface of the contact electrode 180, the lower surface of the metal pattern MP may be located at a lower height than a region a overlapping the filling layer 150b of the source/drain pattern 150 in the third direction D3 and a region b overlapping the first interlayer insulation layer 171 in the third direction D3. As shown in FIG. 7B, the region a and the region b may be located at the same height.

In another embodiment, the region a and the region b may have different heights. For example, the region b may be located at a lower height than the region a. The lower surface of the metal pattern MP may be located at a lower height than the region b, located at a higher height than the region b, or may be located at the same height as the region b.

Referring to FIGS. 7A and 7B, the metal pattern MP may be connected to the through electrode 190 together with the contact electrode 180, and provide a passage through which electrical power may be supplied from the lower wire structure 220 to the source/drain pattern 150. According to an embodiment, a serial resistance component between the through electrode 190 and the source/drain pattern 150 may be decreased, and accordingly, an electric characteristic of a semiconductor device may potentially be improved. Among the configurations shown in FIGS. 7A and 7B, in the case of other configurations excluding the gate separation pattern GC, the detailed configuration and connection relationship may be substantially similar and/or the same as the semiconductor devices described with reference to FIGS. 1 to 5, and consequently, a detailed description thereof may be omitted for the sake of brevity.

FIGS. 8 to 37 are drawings illustrating a method of manufacturing a semiconductor device, according to an embodiment.

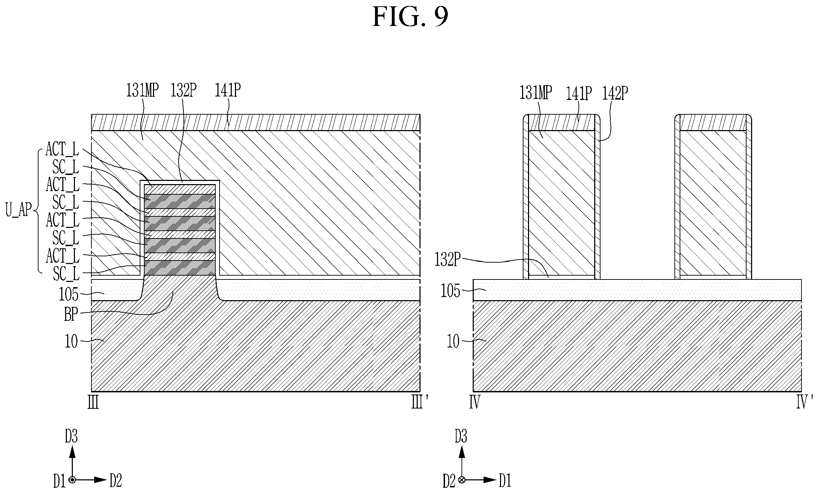

As shown in FIGS. 8 and 9, the field insulation layer 105, the lower pattern BP and an upper pattern structure U_AP may be formed on a substrate 10. The substrate 10 may be silicon-on-insulator (SOI) or bulk silicon. Alternatively or additionally, the substrate 10 may be a silicon (Si) substrate, and may include other materials, for example, silicon germanium (SiGe), Silicon-Germanium on Insulator (SGOI), indium antimonide, lead tellurium compound, indium arsenide, indium phosphide, gallium arsenide, or gallium antimonide, however, the present disclosure is not limited thereto. The lower pattern BP may be and/or may include a portion of the substrate 10.

The upper pattern structure U_AP may be located on the lower pattern BP. The upper pattern structure U_AP may include the sacrificial pattern SC_L and the active pattern ACT_L alternately stacked on the lower pattern BP. For example, the sacrificial pattern SC_L may include silicon germanium (SiGe). The active pattern ACT_L may include silicon (Si). The field insulation layer 105 may cover portions of sidewalls of the lower pattern BP and the upper pattern structure U_AP.

On the upper pattern structure U_AP, a preliminary gate insulation layer 132P, a preliminary main gate electrode 131MP and a preliminary capping layer 141P may be formed. The preliminary gate insulating layer 132P may also be located on the field insulation layer 105. The preliminary gate insulation layer 132P may include, for example, silicon oxide (SiOₓ), however, the present disclosure is not limited thereto. The preliminary main gate electrode 131MP may include, for example, polysilicon, however, the present disclosure is not limited thereto. The preliminary capping layer 141P may include, for example, silicon nitride (SiN), however, the present disclosure is not limited thereto. On both side surfaces of the preliminary main gate electrode 131MP, a preliminary gate spacer 142P may be formed.

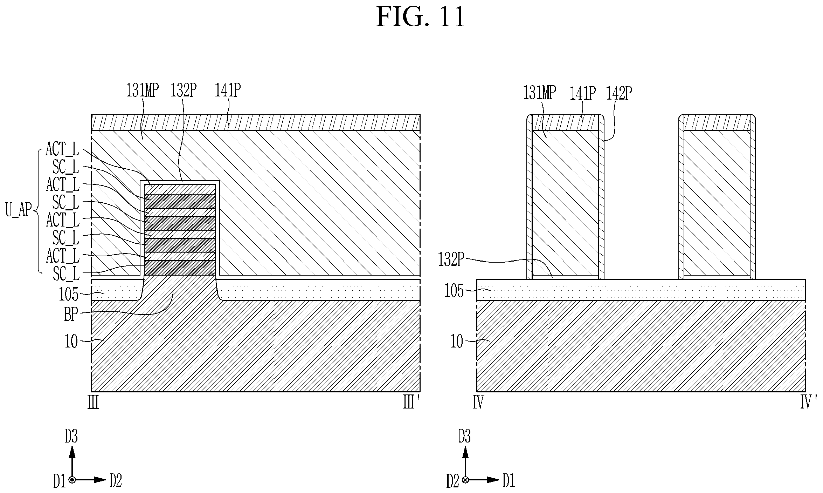

As shown in FIGS. 10 and 11, by using a preliminary capping layer 141P and the preliminary gate spacer 142P as a mask, the source/drain recess RC1 may be formed by etching at least a portion of the upper pattern structure U_AP. As the source/drain recess RC1 is formed, at least a portion of the lower pattern BP may be etched. A portion of the source/drain recess RC1 may be formed within the substrate 10. As shown in FIG. 10, after forming the source/drain recess RC1, an indent process with respect to the sacrificial layer SC_L may be performed. In the indent process, the sacrificial layer SC_L may be etched by the wet etching and/or dry etching method, and accordingly, the length of the sacrificial layer SC_L in the first direction D1 may be further reduced. Accordingly, the surface of the sacrificial layer SC_L contacting the source/drain recess RC1 may have a concave shape toward the source/drain recess RC1.

As the source/drain recess RC1 is formed, the active pattern ACT_L is separated such that the first to fourth channel layers 110a to 110d may be formed. The first to fourth channel layers 110a to 110d may be located on both sides of the source/drain recess RC1. The first to fourth channel layers 110a to 110d and sacrificial patterns SC_L may be alternately stacked in the third direction D3. The lengths of the first to fourth channel layers 110a to 110d may be different, and/or the lengths may be the same.

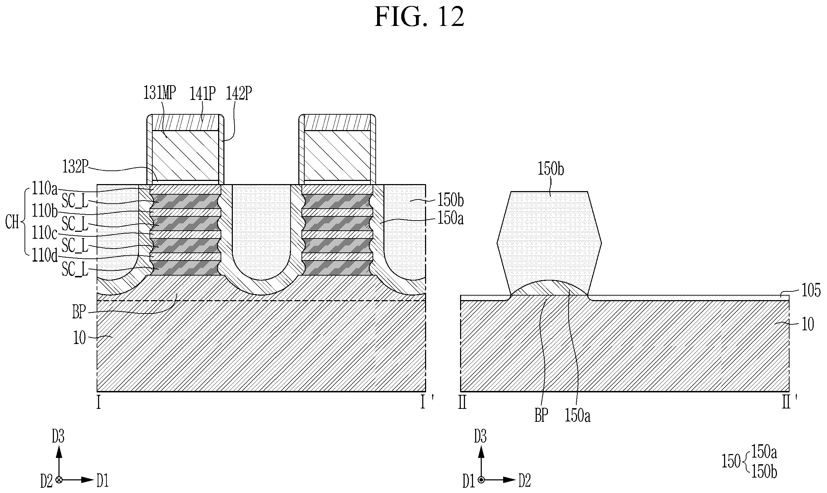

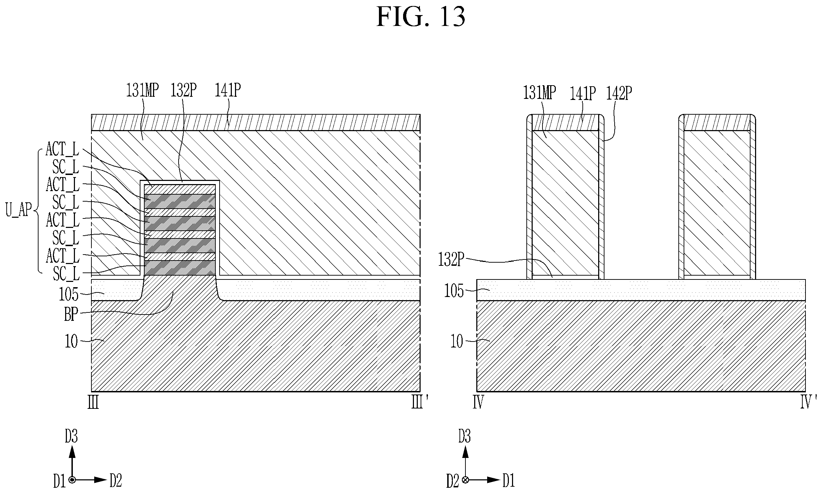

As shown in FIGS. 12 and 13, the source/drain pattern 150 may be formed within the source/drain recess RC1. The source/drain pattern 150 may be formed on the substrate 10. The source/drain pattern 150 may be formed by using an epitaxial growth method. The inner wall of the source/drain recess may be used as a seed. The source/drain pattern 150 may directly contact the substrate 10 or the lower pattern BP. The source/drain pattern 150 may directly contact the first to fourth channel layers 110a to 110d and sacrificial layers SC_L. The source/drain pattern 150 may include silicon (Si), germanium (Ge) or silicon germanium (SiGe). The source/drain pattern 150 may be formed of several regions having different concentrations. For example, referring to FIG. 12, the source/drain pattern 150 may include the liner layer 150a and the filling layer 150b. The liner layer 150a and the filling layer 150b may be sequentially formed. That is, first, the liner layer 150a may be formed along the sidewall and bottom surface of the source/drain recess RC1, and filling layers 150b may be formed on each liner layer 150a. Each of the liner layer 150a and the filling layers 150b may be formed by using an epitaxial growth method. The liner layer 150a and the filling layer 150b may include a semiconductor material. For example, the liner layer 150a and the filling layer 150b may include silicon (Si) or germanium (Ge), which are elemental semiconductor materials. In an embodiment, the liner layer 150a and the filling layer 150b may have different concentrations of silicon (Si), or germanium (Ge). For example, the concentration of silicon (Si) or germanium (Ge) included in the liner layers 150a may be smaller than the concentration of silicon (Si) or germanium (Ge) included in the filling layer 150b.

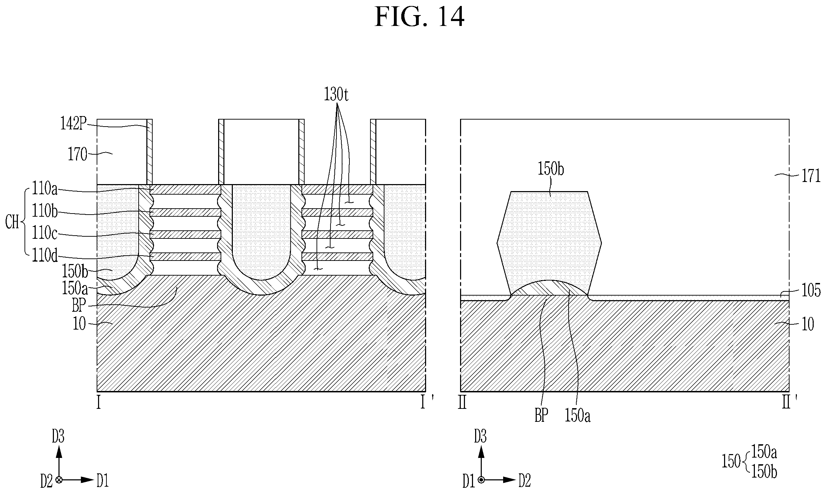

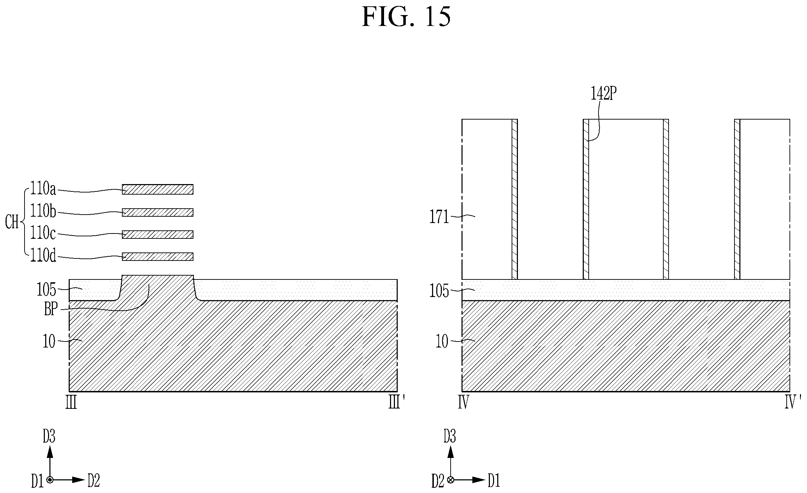

As shown in FIGS. 14 and 15, the first interlayer insulation layer 171 may be formed on the source/drain pattern 150. Subsequently, a portion of the first interlayer insulation layer 171 and the preliminary capping layer 141P may be removed, so as to expose an upper surface of the preliminary main gate electrode 131MP. In an embodiment, a portion of the gate spacer 142P may be removed together, and the gate spacer 142 may be formed. Thereafter, by removing remaining preliminary gate insulating layers 132P and the preliminary main gate electrodes 131MP, the upper pattern structure U_AP between the gate spacers 142 may be exposed. Subsequently, the sacrificial pattern SC_L between the channel layers CH and the lower pattern BP may be removed, and thereby a gate trench 130t may be formed.

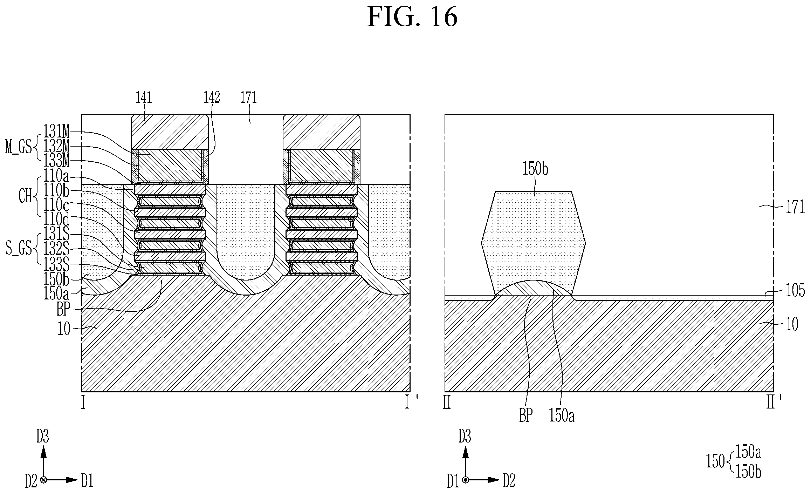

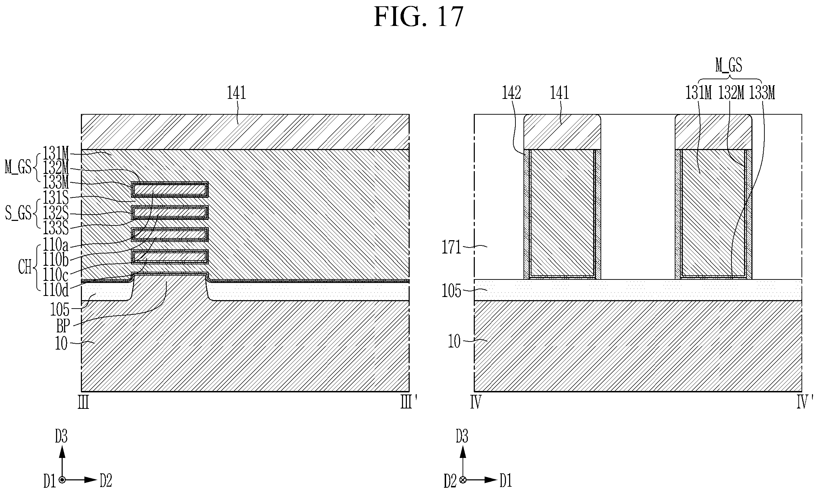

As shown in FIGS. 16 and 17, the sub-interface insulation layer 133S, the sub-gate insulation layer 132S, the sub-gate electrode 131S may be sequentially formed within the gate trench 130t. In addition, the main interface insulation layer 133M, the main gate insulation layer 132M, the main gate electrode 131M, and the capping layer 141 may be sequentially formed. The sub-interface insulation layer 133S and the main interface insulation layer 133M may be simultaneously formed in the same process. The sub-gate insulation layer 132S and the main gate insulation layer 132M may be simultaneously (e.g., at a substantially similar time) formed in the same process. The sub-gate electrode 131S and the main gate electrode 131M may be simultaneously formed in the same process.

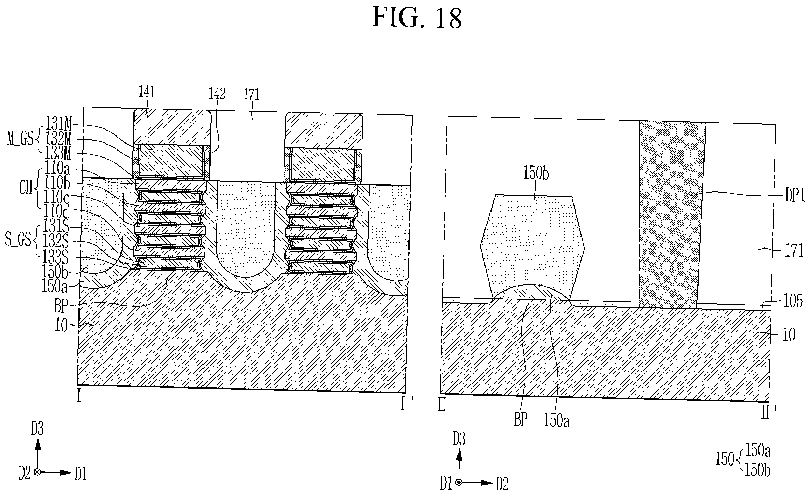

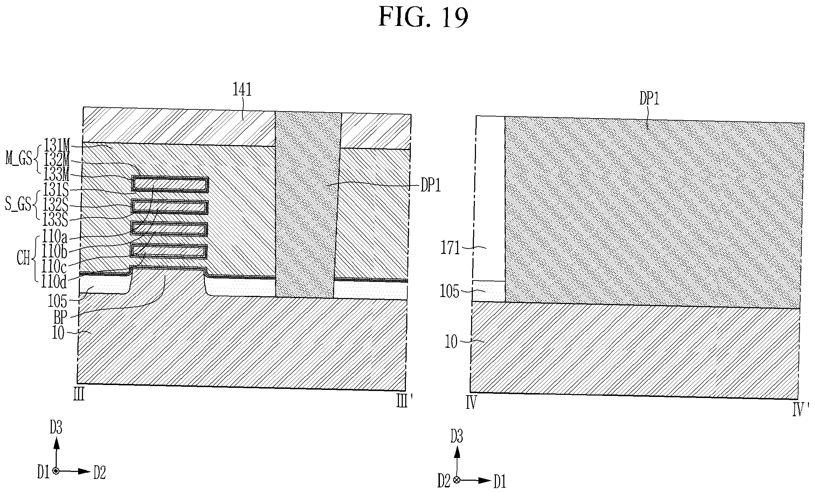

As shown in FIGS. 18 and 19, by etching a portion of the main gate structure M_GS and filling the etched portion with an insulating material, the first insulation pattern DP1 may be formed. For example, by patterning the capping layer 141, the main gate electrode 131M, the main gate insulating layer 132M and the main interface insulation layer 133M, the first insulation pattern DP1 extending in the first direction D1 may be formed. The capping layer 141, the main gate electrode 131M, the main gate insulating layer 132M and the main interface insulation layer 133M may be sequentially etched. The first insulation pattern DP1 may cross the capping layer 141, the main gate electrode 131M, the main gate insulating layer 132M and the main interface insulation layer 133M. The first insulation pattern DP1 may penetrate the capping layer 141, the main gate electrode 131M, the main gate insulating layer 132M and the main interface insulation layer 133M in the third direction D3. The first insulation pattern DP1 may penetrate the field insulation layer 105 in the third direction D3 located below the main gate electrode 131M, and may contact an upper surface of the substrate 10. In an embodiment, the first insulation pattern DP1 may include an insulating material having etch selectivity compared to the interlayer insulation layer 170.

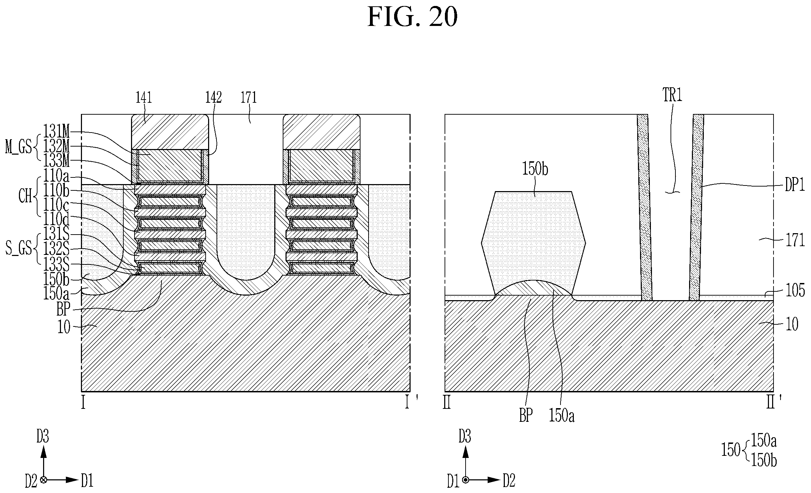

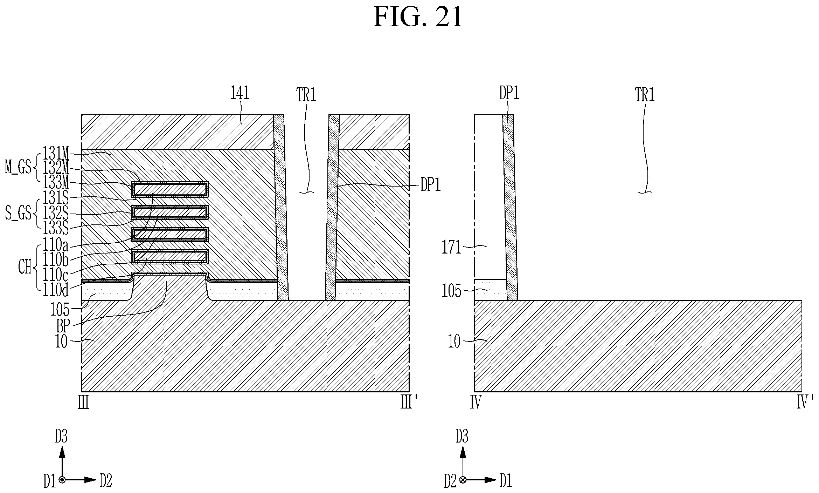

As shown in FIGS. 20 and 21, by etching a partial region of the first insulation pattern DP1, a first trench TR1 exposing a portion of the upper surface of the substrate 10 may be formed. A sidewall of the first trench TR1 may be surrounded by a first insulation pattern D1.

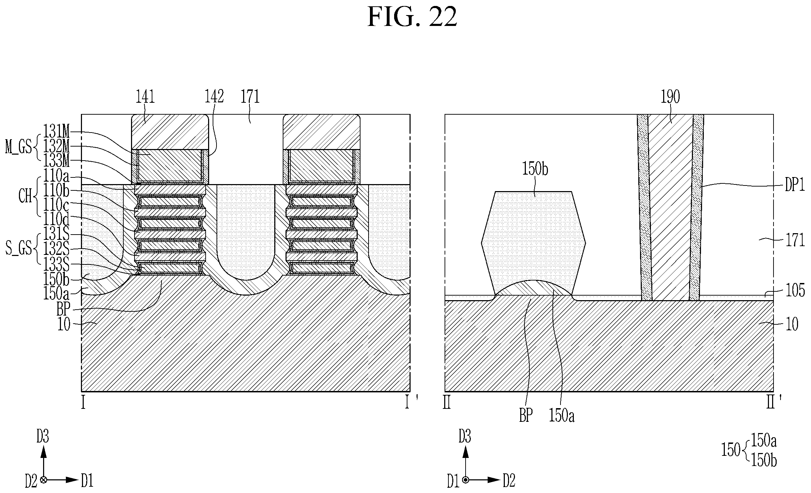

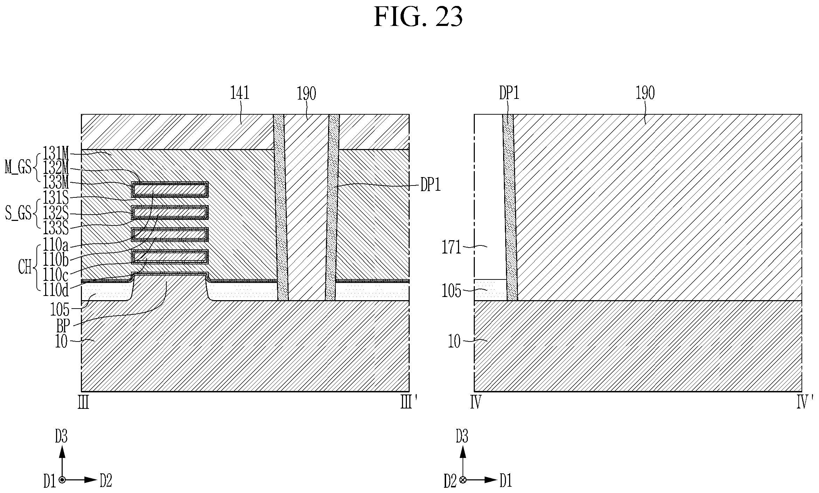

As shown in FIGS. 22 and 23, the through electrode 190 may be formed by filling the first trench TR1 with a metallic material. The upper surface of the through electrode 190 may be located on the same plane as the upper surface of the first insulation pattern DP1. The sidewall of the through electrode 190 may be surrounded by the first insulation pattern DP1. The lower surface of the through electrode 190 may contact the upper surface of the substrate 10.

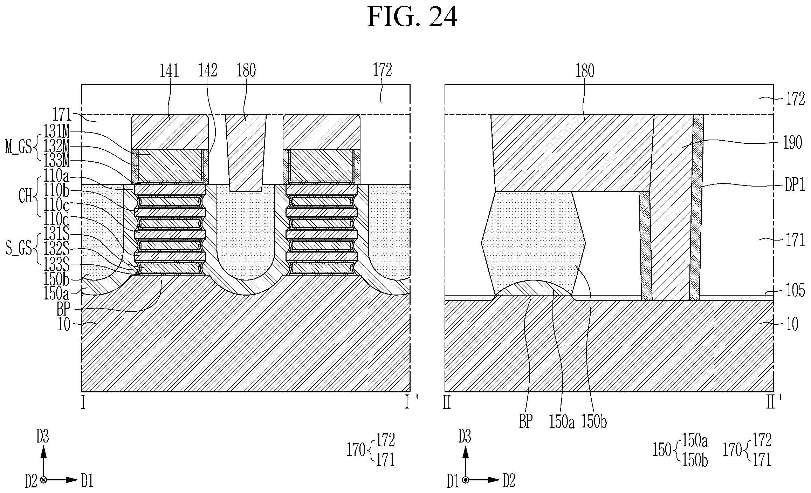

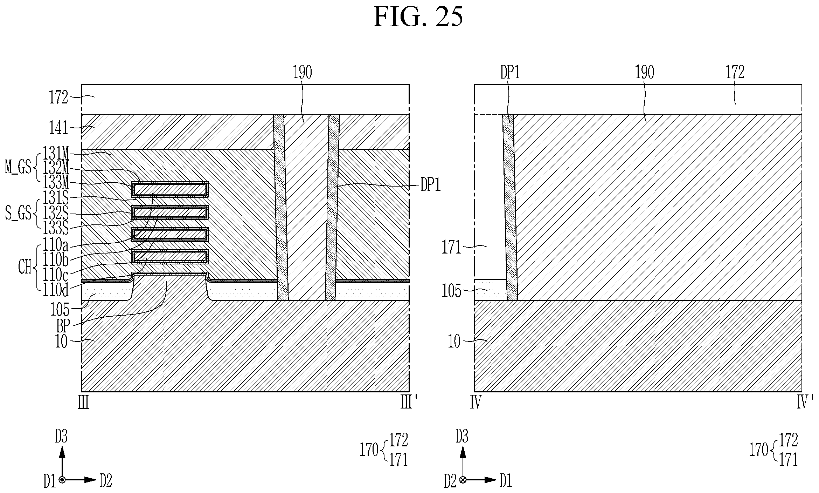

As shown in FIGS. 24 and 25, by patterning a portion of the first insulation pattern DP1 and the first interlayer insulation layer 171, the contact electrode 180 contacting the upper surface of the source/drain pattern 150 and the through electrode 190 may be formed. That is, by etching a portion of the first insulation pattern DP1 and the interlayer insulation layer 170, a portion of the sidewall of the through electrode 190 and the upper surface of the source/drain pattern 150 are exposed, and the contact electrode 180 may be formed by filling the etched portion with a metallic material. In an embodiment, among both sidewalls of the through electrode 190, a partial region of the first insulation pattern DP1 contacting one sidewall adjacent to the source/drain pattern 150 may be removed. Accordingly, the contact electrode 180 may commonly contact the source/drain pattern 150 and the through electrode 190. After forming the contact electrode 180, the second interlayer insulation layer 172 that covers the first interlayer insulation layer 171, the upper surface of the gate separation pattern GC, the upper surface of the contact electrode 180, and an upper surface of the gate structure GS may be formed.

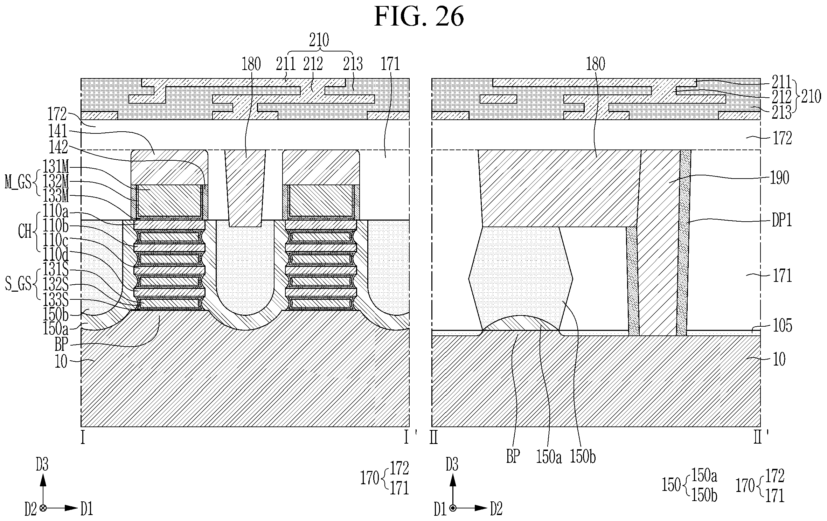

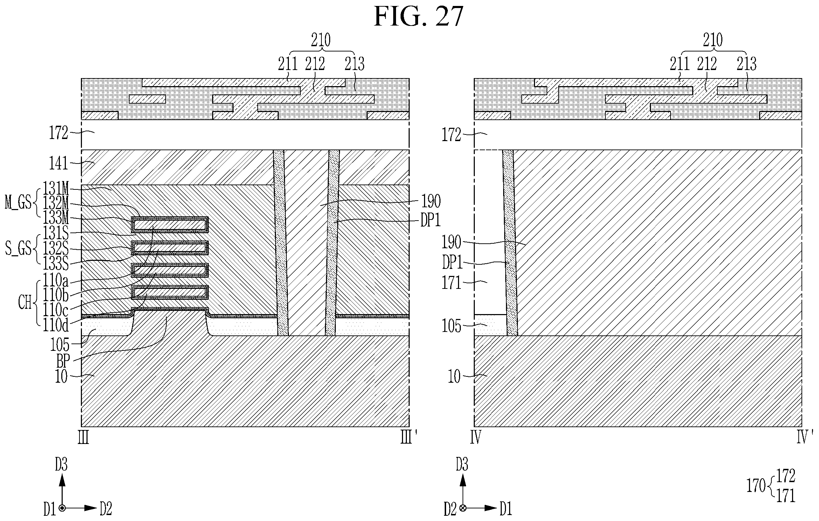

As shown in FIGS. 26 and 27, the upper wire structure 210 may be formed on the second interlayer insulation layer 172. The upper wire structure 210 may include upper wires 211, an upper via or vias 212 and an upper insulation layer 213. In an embodiment, the upper wire structure 210 may include the upper wires 211 of various layers formed through a plurality of repeated processes. For example, after one layer of the upper insulation layer 213 is deposited on an upper surface of the interlayer insulation layer 170, it is patterned, and the upper wire 211 may be formed. Thereafter, after one layer of the upper insulation layer 213 is deposited again, it is patterned, and the upper via 212 may be formed on the upper wire 211. Thereafter, the upper wire 211 connected to a second end of the upper via 212 may be formed. The upper wires 211 and the upper vias 212 may include a metal (e.g., copper (Cu)). The upper insulation layer 213 may be located on the upper surface of the interlayer insulation layer 170. The upper insulation layer 213 may cover the upper wires 211 and the upper vias 212. That is, the upper wires 211 and the upper vias 212 may be disposed within the upper insulation layer 213. The upper insulation layer 213 may include, for example, at least one of silicon oxide (SiOₓ), silicon nitride (SiNₓ), silicon nitride oxide (SiON), or low dielectric layers.

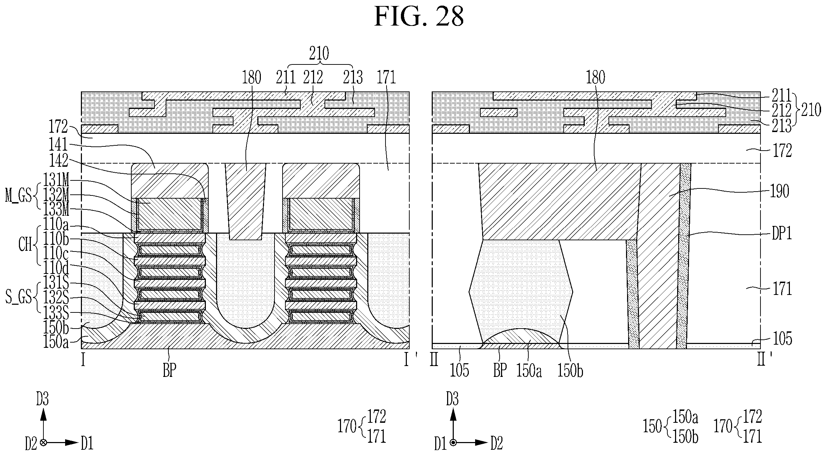

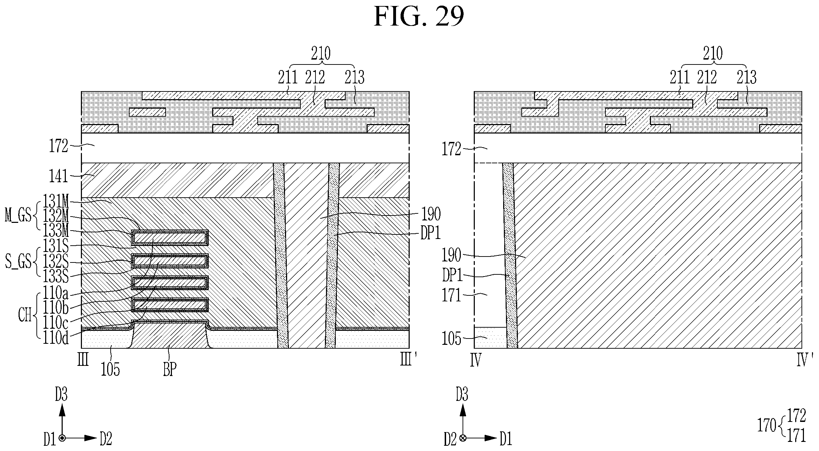

As shown in FIGS. 28 and 29, the substrate 10 may be removed by performing an etching process. The process of thinning the substrate 10 by performing a chemical mechanical polishing (CMP) process with respect to a lower surface of the substrate 10 may be performed. The etching process of removing the substrate 10 may be performed, for example, by a wet etching method. However, the present disclosure is not limited thereto, the substrate 10 may be removed by a dry etching process. As a partial region of the substrate 10 is removed, the lower surface of the through electrode 190 and the first insulation pattern DP1 may be exposed. Another region of the substrate 10 that remains by not being removed may form the lower pattern BP.

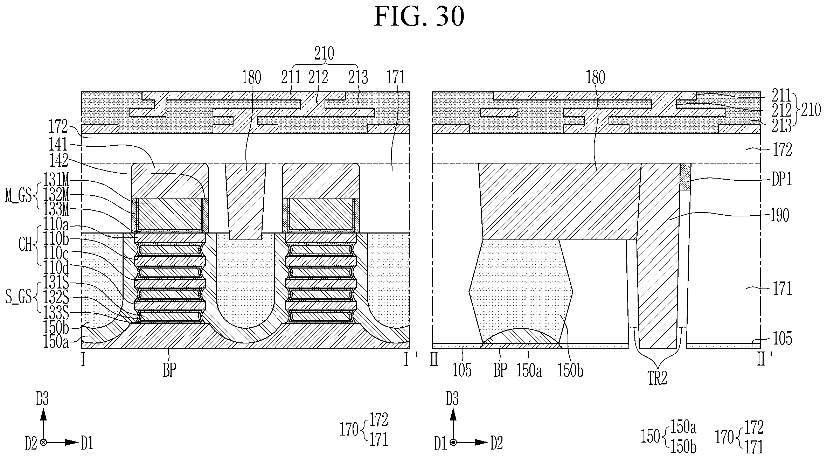

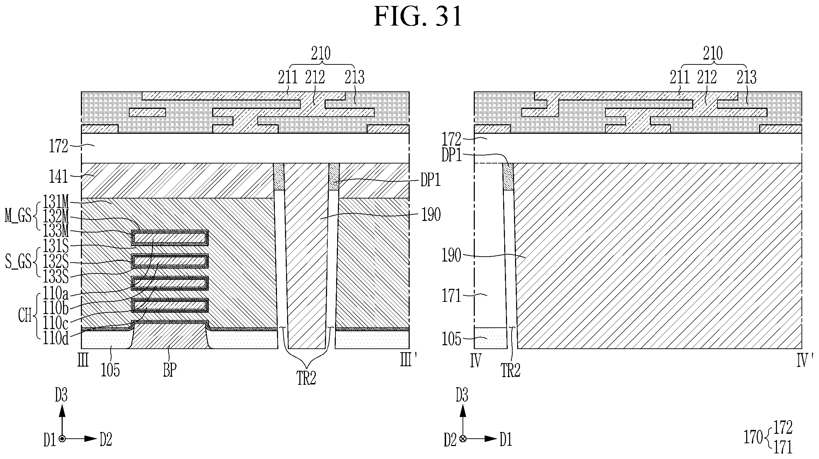

As shown in FIGS. 30 and 31, a second trench TR2 may be formed by selectively etching a partial region of the first insulation pattern DP1. The field insulation layer 105 and the first insulation pattern DP1 may be sequentially etched, and may be etched together in the same process. In an embodiment, the field insulation layer 105 and the first insulation pattern DP1 may be etched by dry etching process. However, the present disclosure is not limited thereto, and the field insulation layer 105 and the first insulation pattern DP1 may be etched by a wet etching process. In such an embodiment, a portion of the first insulation pattern DP1 may be etched by using an etchant having higher etch selectivity with respect to the first insulation pattern DP1 compared to the interlayer insulation layer 170. As the second trench TR2 is formed, a portion of the lower surface of the contact electrode 180 and the sidewall of the through electrode 190 may be exposed. In an embodiment, the first insulation pattern DP1 may be etched until the lower surface is located at a level higher than or equal to the upper surface of the source/drain pattern 150. However, the present disclosure is not limited thereto, and the first insulation pattern DP1 may be etched until the lower surface is lower than the upper surface of the source/drain pattern 150 and located at a higher level than the lower surface of the source/drain pattern 150.

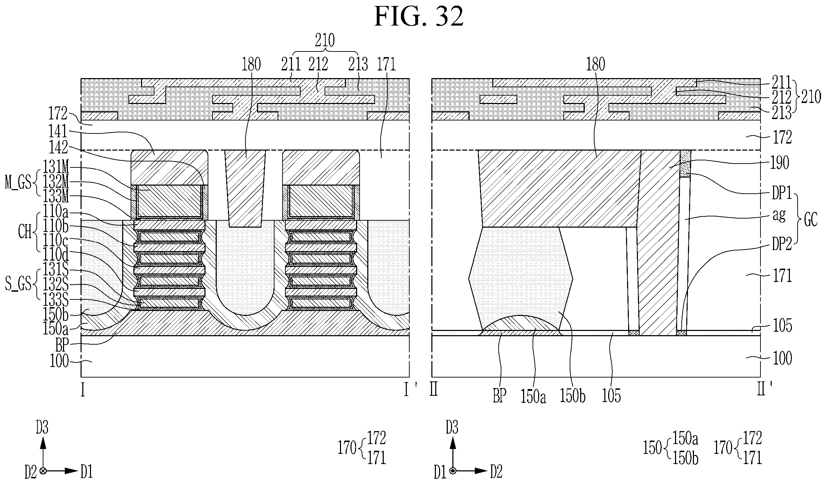

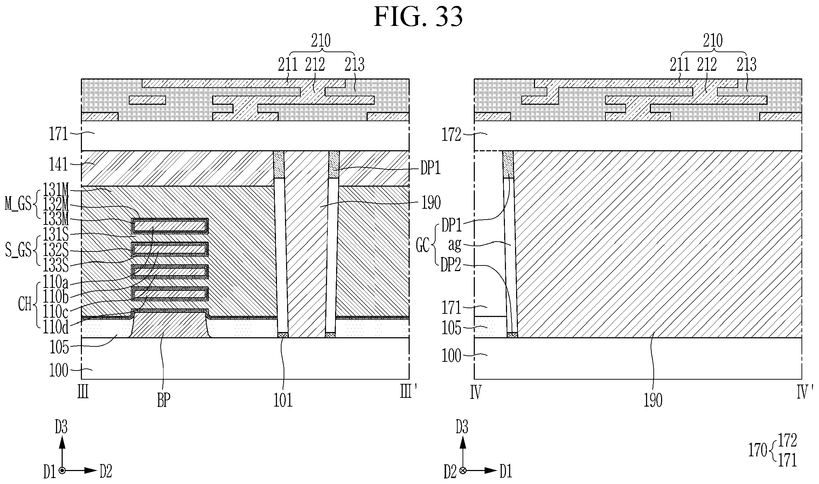

As shown in FIGS. 32 and 33, in the region from which the substrate 10 is removed, the base insulation layer 100 covering the lower pattern BP, the field insulation layer 105, lower surface of the second trench TR2 and the lower surface of the through electrode 190 may be formed.

In an embodiment, since a width of the second trench TR2 in the second direction D2 may be relatively narrow, the base insulation layer 100 may not be formed in a deep location of the second trench TR2 (e.g., a location adjacent to the lower surface of the first insulation pattern DP1 or the contact electrode 180). However, the base insulation layer 100 formed on the second trench TR2 may protrude into the second trench TR2 by gravitation, and the second insulation pattern DP2 may be formed. In such an embodiment, the second insulation pattern DP2 may be controlled to have an upper surface of a level lower than or equal to the lower surface of the source/drain pattern 150. In another embodiment, the second insulation pattern DP2 may be controlled to have an upper surface of a level higher than the lower surface of the source/drain pattern 150. The air gap ag may be located between the second insulation pattern DP2 and the first insulation pattern DP1. Accordingly, the first insulation pattern DP1, the second insulation pattern DP2 and the air gap ag may form the gate separation pattern GC.

In an embodiment, the second insulation pattern DP2 may be formed in a process separate and different from the process of forming the base insulation layer 100. For example, in the region from which the substrate 10 is removed, after forming the second insulation pattern DP2 protruding from the lower surface of the second trench TR2 into the second trench TR2, the base insulation layer 100 that covers the lower pattern BP, the field insulation layer 105, the lower surface of the second insulation pattern DP2 and the lower surface of the through electrode 190 may be formed. In such an embodiment, the second insulation pattern DP2 may include an insulating material different from the insulating material included in the base insulation layer 100. However, the present disclosure is not limited thereto, the second insulation pattern DP2 may include the same insulating material as the insulating material included in the base insulation layer 100.

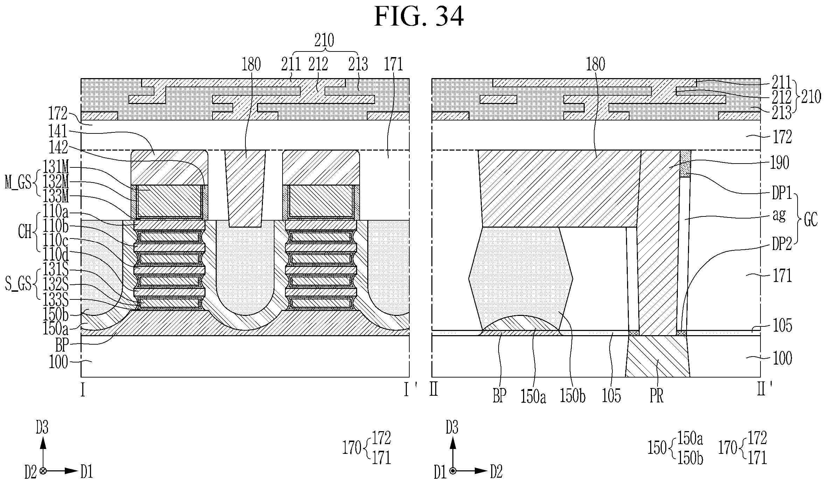

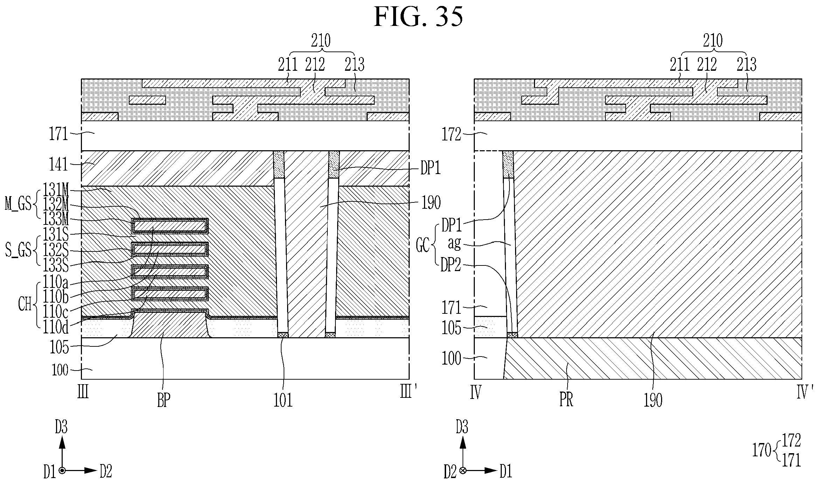

As shown in FIGS. 34 and 35, by etching a partial region of the base insulation layer 100, the power rail PR penetrating the base insulation layer 100 in the third direction D3 may be formed. That is, the power rail PR may be formed in a partial region of the base insulation layer 100 overlapping the through electrode 190 and/or the gate separation pattern GC in the third direction D3. The upper surface of the power rail PR may contact a lower surface of a second insulation pattern DP2 and the through electrode 190. The power rail PR may extend in the first direction D1.

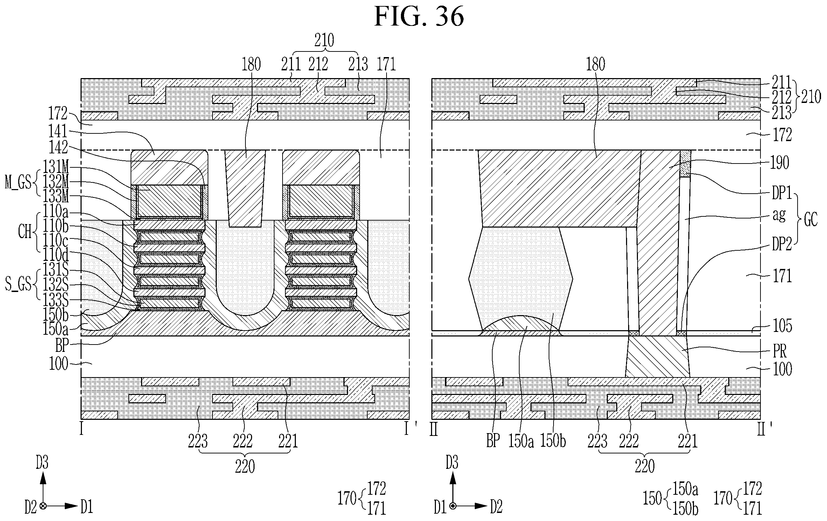

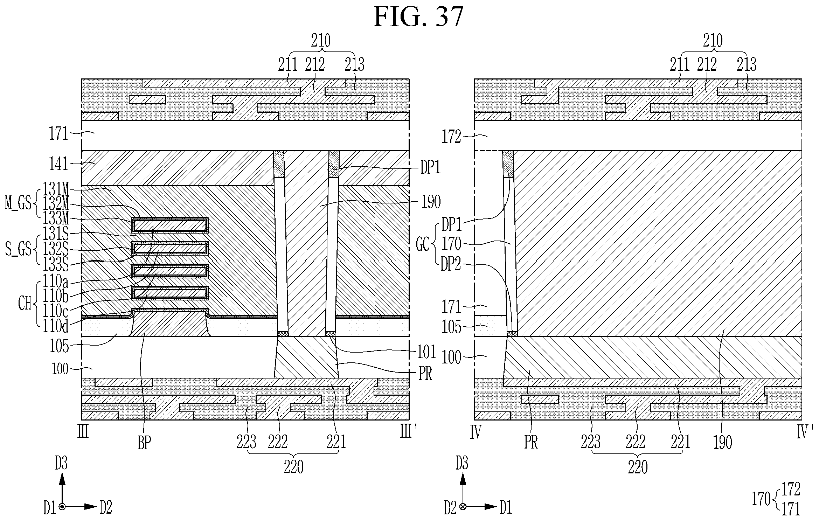

As shown in FIGS. 36 and 37, the lower wire structure 220 may be formed on the lower surface of the base insulation layer 100. In an embodiment, the lower wire structure 220 may include the lower wires 221 of various layers formed through a plurality of repeated processes. For example, after one layer of the lower insulation layer 223 is deposited on the bottom surface of the base insulation layer 100, the lower insulation layer 223 may be patterned, and the lower wire 221 connected to the power rail PR may be formed. Thereafter, after one layer of the lower insulation layer 223 is deposited again, the lower insulation layer 223 may be patterned, and a lower via 222 may be formed on the lower wire 221 connected to the power rail PR. Thereafter, the lower wire 221 connected to a second end of the lower via 222 may be formed. The lower wires 221 and the lower vias 222 may include a metal (e.g., copper (Cu)). The lower insulation layer 223 may be located on the bottom surface of the base insulation layer 100. The lower insulation layer 223 may cover the lower wires 221 and the lower vias 222. That is, the lower wires 221 and the lower vias 222 may be disposed within the lower insulation layer 223. The lower insulation layer 223 may include, for example, at least one of silicon oxide (SiOₓ), silicon nitride (SiNₓ), silicon nitride oxide (SiON), or low dielectric layers.

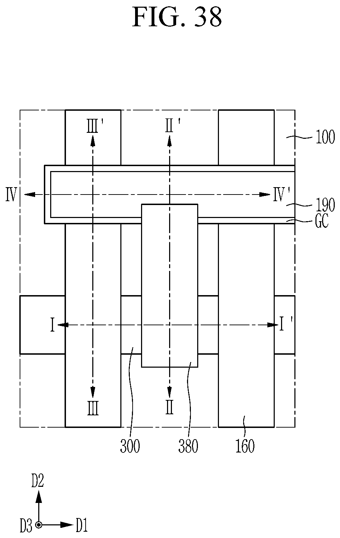

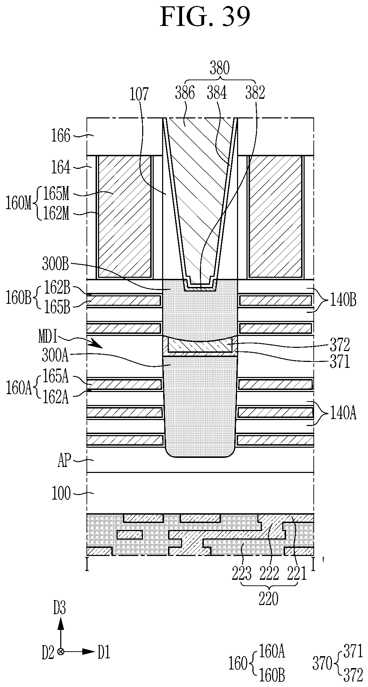

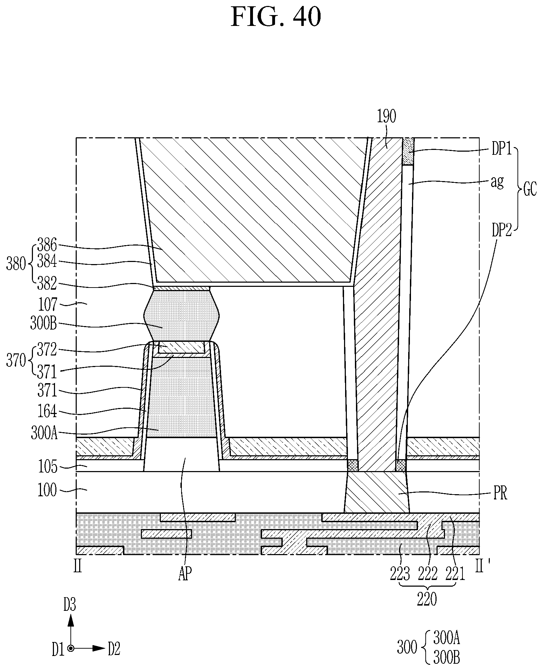

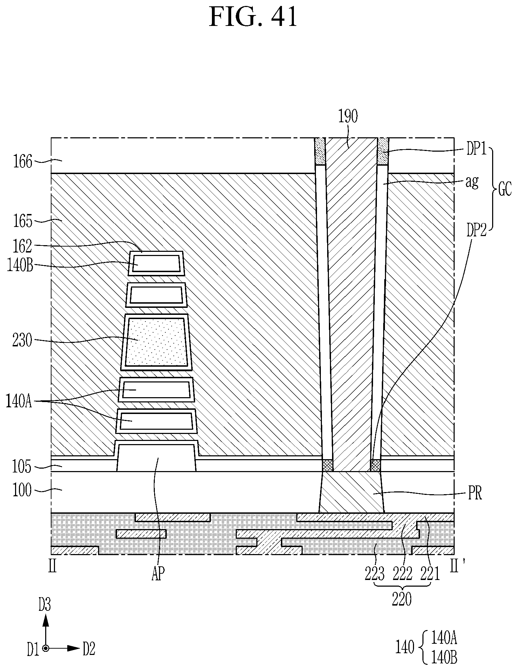

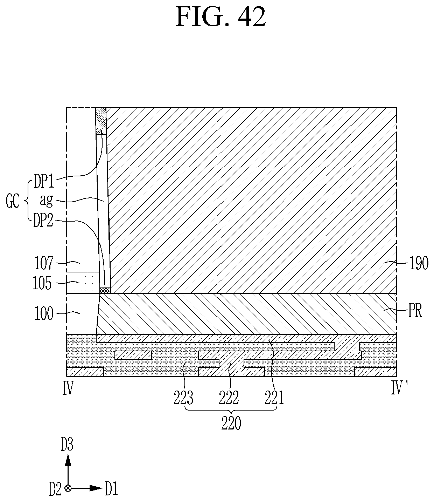

FIG. 38 is a top plan view showing a semiconductor device according to an embodiment. FIGS. 39 to 42 are cross-sectional views showing a semiconductor device, according to an embodiment. Referring to FIG. 39, a cross-sectional view of a semiconductor device taken along line I-I' of FIG. 38 is illustrated. FIG. 40 is a cross-sectional view of a semiconductor device taken along line II-II' of FIG. 38. FIG. 41 is a cross-sectional view of a semiconductor device taken along line III-III' of FIG. 38. FIG. 42 is a cross-sectional view of a semiconductor device taken along line IV-IV' of FIG. 38.

In an embodiment, the semiconductor device may include transistors of a complementary FET (CFET) structure. In an embodiment, the semiconductor device may include transistors of a 3-dimensional (3D) stack FET (3DSFET) structure in which a plurality of transistors may be vertically stacked.

Referring to FIGS. 38 to 42, a semiconductor device, according to an embodiment, may include a base insulation layer 100, an active pattern AP located on the base insulation layer 100, a plurality of channel patterns 140 located on the active pattern AP and including a lower channel pattern 140A and an upper channel pattern 140B, a middle dielectric isolation structure MDI located between the lower channel pattern 140A and the upper channel pattern 140B, a field insulation layer 105 located on the base insulation layer 100, a gate structure 160 located on the active pattern AP, source/drain patterns 300 located on at least a first side of the gate structure 160 and including a lower source/drain pattern 300A and an upper source/drain pattern 300B, and a barrier structure 370 located between the lower source/drain pattern 300A and the upper source/drain pattern 300B and a gate separation pattern GC crossing the gate structure 160.

The base insulation layer 100 may include an insulating material. The base insulation layer 100 may include, for example, a layer of oxide, nitride, nitride oxide, or a combination thereof. For example, the base insulation layer 100 may include, but is not limited to, silicon nitride (SiNₓ). Although the base insulation layer 100 is illustrated as a single layer, this is merely for the convenience of explanation, and the present disclosure is not limited thereto. The first surface and the second surface of the base insulation layer 100 may be formed as a plane parallel to the first direction D1 and the second direction D2 crossing the first direction D1. For example, the first surface of the base insulation layer 100 may be an upper surface, and the second surface may be a bottom surface. The upper surface of the base insulation layer 100 is a surface opposite to the bottom surface of the base insulation layer 100 in the third direction D3. The third direction D3 may be a direction perpendicular to the first direction D1 and the second direction D2. The bottom surface of the base insulation layer 100 may be referred to as a backside of the base insulation layer 100. In some embodiments, a logic circuit in a cell region may be implemented on the upper surface of the base insulation layer 100. The base insulation layer 100 may include an upper surface and a bottom surface. The upper surface and the lower surface of the base insulation layer 100 may be formed as a plane parallel to the first direction D1 (X-direction) and the second direction D2 crossing the first direction D1 (X-direction). The upper surface of the base insulation layer 100 may be a surface opposite to the bottom surface of the base insulation layer 100 in the third direction D3. The upper surface of the base insulation layer 100 may be referred to as a front side. The bottom surface of the base insulation layer 100 may be referred to as a back side. In some embodiments, a logic circuit in a cell region may be implemented on the upper surface of the base insulation layer 100.

The active pattern AP may be located on the base insulation layer 100. The active pattern AP may extend in the first direction D1. The active pattern AP may have a structure that protrudes from the base insulation layer 100. An upper surface of the active pattern AP may be located to protrude from the upper surface of the field insulation layer 105, however, the present disclosure is not limited thereto. The active pattern AP may be one formed by etching a portion of the base insulation layer 100, and may include an epitaxial layer grown from the base insulation layer 100. The active pattern AP may include silicon (Si) or germanium (Ge), which are elemental semiconductor materials. The active pattern AP may include impurities, or doping regions including impurities.

A semiconductor device, according to an embodiment, may include a plurality of transistor structures. For example, a semiconductor device, according to an embodiment, may include a first transistor structure including a plurality of lower channel patterns 140A and a second transistor structure including a plurality of upper channel patterns 140B. The first and second transistor structures, according to an embodiment, may be formed in a multi-bridge channel field effect transistor (MBCFET^{™}) in which the plurality of lower channel patterns 140A and the plurality of upper channel patterns 140B are surrounded by the gate structure 160.

In addition, the first and second transistor structures, according to an embodiment, may be formed in a 3D stack field effect transistor (3D-SFET) structure that may be stacked in the third direction D3. The first transistor structure may be one of an N-type MOSFET and a P-type MOSFET, and the second transistor structure may be the other one of P-type MOSFET and N-type MOSFET. In an embodiment, the first and second transistor structures may be N-type MOSFETs and P-type MOSFETs, respectively, however, the present disclosure is not limited thereto. Hereinafter, an example in which the plurality of lower channel patterns 140A and the plurality of upper channel patterns 140B are stacked in the third direction D3 to form the 3D-SFET structure is described. However, the present disclosure is not limited thereto.

The plurality of channel patterns 140 may be located on the active pattern AP. In an embodiment, the plurality of channel patterns 140 may include the plurality of lower channel patterns 140A located on the active pattern AP and the plurality of upper channel patterns 140B located on the plurality of lower channel patterns 140A.

The plurality of lower channel patterns 140A may be located on the upper surface of the active pattern AP. The plurality of lower channel patterns 140A may be spaced apart from the active pattern AP in the third direction D3. Each of the plurality of lower channel patterns 140A may be spaced apart in the third direction D3.

In an embodiment, as shown in FIG. 41, widths of the plurality of lower channel patterns 140A along the second direction D2 may decrease away from the upper surface of the base insulation layer 100. In addition, as shown in FIG. 39, widths of the plurality of lower channel patterns 140A along the first direction D1 may decrease away from the upper surface of the base insulation layer 100. However, the present disclosure is not limited thereto, and widths of the plurality of lower channel patterns 140A along the second direction D2 may be substantially similar and/or the same. In addition, widths of the plurality of lower channel patterns 140A along the first direction D1 may be substantially similar and/or the same.

The plurality of upper channel patterns 140B may be located on the plurality of lower channel patterns 140A. That is, the plurality of upper channel patterns 140B may be located on an upper surface of the middle dielectric isolation structure MDI located on the plurality of lower channel patterns 140A. The plurality of upper channel patterns 140B may be spaced apart from the plurality of lower channel patterns 140A in the third direction D3. For example, the middle dielectric isolation structure MDI may be located between the plurality of upper channel patterns 140B and the plurality of lower channel patterns 140A, and the plurality of upper channel patterns 140B may be located to be spaced apart from the plurality of lower channel patterns 140A in the third direction D3 by the middle dielectric isolation structure MDI. Each of the plurality of upper channel patterns 140B may be spaced apart in the third direction D3.

In an embodiment, as shown in FIG. 41, widths of the plurality of upper channel patterns 140B along the second direction D2 may decrease away from the upper surface of the base insulation layer 100. However, the present disclosure is not limited thereto, widths of the plurality of upper channel patterns 140B along the second direction D2 may be substantially similar and/or the same. In addition, as shown in FIG. 39, widths of the plurality of upper channel patterns 140B along the first direction D1 may be substantially similar and/or the same, however, the present disclosure is not limited thereto.

The plurality of lower channel patterns 140A and the plurality of upper channel patterns 140B may be a multi-channel active pattern. In an embodiment, the active pattern AP, the plurality of lower channel patterns 140A, and the plurality of upper channel patterns 140B may have a nanosheet shape, and may be a semiconductor pattern including a semiconductor material.

The plurality of lower channel patterns 140A and the plurality of upper channel patterns 140B may be one formed by etching a portion of the base insulation layer 100, and may include an epitaxial layer grown from the base insulation layer 100. The plurality of lower channel patterns 140A and the plurality of upper channel patterns 140B may include silicon (Si) or germanium (Ge), which are elemental semiconductor materials. In addition, the plurality of lower channel patterns 140A and the plurality of upper channel patterns 140B may include a compound semiconductor, and may include, for example, an IV-IV group compound semiconductor or an III-V group compound semiconductor.

The plurality of lower channel patterns 140A and each of the plurality of upper channel patterns 140B may include a substantially similar and/or the same material as the active pattern AP, and may include a different material from the active pattern AP.

The IV-IV group compound semiconductor may be, for example, a binary compound or a ternary compound including at least two or more of carbon (C), silicon (Si), germanium (Ge), and tin (Sn).

The III-V group compound semiconductor may be, for example, one of binary compound, ternary compound, or quaternary compound, which is formed by combining at least one of aluminum (Al), gallium (Ga) and indium (In) as a group III element and one of phosphorus (P), arsenic (As) and antimonium (Sb) as a group V element.

In an embodiment, the active pattern AP and the plurality of channel patterns 140 may include silicon (Si). As another example, the active pattern AP and the plurality of channel patterns 140 may include silicon germanium (SiGe). As yet another example, the active pattern AP may include silicon (Si), and the plurality of channel patterns 140 may include silicon germanium (SiGe).

In FIGS. 39 and 41, although two lower channel patterns 140A and two upper channel patterns 140B are illustrated as being stacked to be spaced apart along the third direction D3, this is merely for better understanding and ease of description, and the present disclosure is not limited thereto. For example, three (3) or more the plurality of lower channel patterns 140A and/or three (3) or more the plurality of upper channel patterns 140B may be stacked to be spaced apart along the third direction D3. Alternatively or additionally, one lower channel pattern 140A and/or one upper channel pattern 140B may be stacked to be spaced apart along the third direction D3.

The middle dielectric isolation structure MDI may be located on the plurality of lower channel patterns 140A. The middle dielectric isolation structure MDI may be located between an uppermost lower channel pattern 140A and a lowermost upper gate structure 160B.

The middle dielectric isolation structure MDI may include an intermediate insulation pattern 230. The intermediate insulation pattern 230 may include various insulating materials. For example, the intermediate insulation pattern 230 may include silicon oxide (SiO), silicon nitride (SiN), silicon nitride oxide (SiON), a combination thereof, or the like. The middle dielectric isolation structure MDI may space the plurality of lower channel patterns 140A and the plurality of upper channel patterns 140B apart from each other.

In an embodiment, the middle dielectric isolation structure MDI has been described to include a single intermediate insulation pattern 230, however, the present disclosure is not limited thereto. For example, the middle dielectric isolation structure MDI may include a plurality of intermediate insulation patterns 230. Alternatively or additionally, the middle dielectric isolation structure MDI may include a semiconductor pattern located between the plurality of intermediate insulation patterns 230. In such an embodiment, the plurality of upper channel patterns 140B and the plurality of lower channel patterns 140A may be spaced apart by the middle dielectric isolation structure MDI.

The field insulation layer 105 may be located on the base insulation layer 100. The field insulation layer 105 may cover at least a portion of a side surface of the active pattern AP. For example, as shown in FIG. 41, the field insulation layer 105 may cover a portion of the side surface of the active pattern AP. That is, a portion of the side surface of the active pattern AP may be covered by the field insulation layer 105, and a remaining portion of the sidewall of the active pattern AP may be covered by the gate structure 160. The field insulation layer 105 may overlap the active pattern AP in the second direction D2. In addition, the field insulation layer 105 may not be located on the upper surface of the active pattern AP. In an embodiment, the upper surface of the field insulation layer 105 is illustrated to extend in a direction parallel to the upper surface of the base insulation layer 100, however, the present disclosure is not limited thereto. For example, the field insulation layer 105 may have a curved upper surface having a level becoming higher as being closer to the active pattern AP.

FIG. 41 illustrates that the field insulation layer 105 covers at least a portion of the side surface of the active pattern AP, however, the present disclosure is not limited thereto. For example, the field insulation layer 105 may entirely cover the side surface of the active pattern AP. In such an embodiment, the side surface of the active pattern AP may be completely covered by the field insulation layer 105.

The field insulation layer 105 may include, for example, a layer of oxide, nitride, nitride oxide, or a combination thereof. Although the field insulation layer 105 is illustrated as having a single layer, this is merely for the convenience of explanation, and the present disclosure is not limited thereto.

The gate structure 160 may be located on the active pattern AP. The gate structure 160 may extend in the second direction D2. The gate structure 160 may be located to be spaced apart in the first direction D1. The gate structure 160 may be located on the active pattern AP. The gate structure 160 may cross the active pattern AP. The gate structure 160 may surround the plurality of channel patterns 140, respectively.

In an embodiment, the first and second transistor structures may be configured to share one gate structure 160. That is, the first transistor structure may include the plurality of lower channel patterns 140A, the gate structure 160 surrounding the plurality of lower channel patterns 140A, and the lower source/drain pattern 300A connected to the plurality of lower channel patterns 140A on a side of the gate structure 160. In addition, the second transistor structure may include the plurality of upper channel patterns 140B, the gate structure 160 surrounding the plurality of upper channel patterns 140B, and the upper source/drain pattern 300B connected to the plurality of upper channel patterns 140B on a side of the gate structure 160. As shown in FIG. 41, since one gate structure 160 surrounds the plurality of lower channel patterns 140A and the plurality of upper channel patterns 140B together, the first and second transistor structures may be configured to share one gate structure 160.

The gate structure 160 may include a lower gate structure 160A, the upper gate structure 160B, and a main gate structure 160M. The lower gate structure 160A may be located between the plurality of lower channel patterns 140A adjacent to each other in the third direction D3, between the active pattern AP and a lowermost lower channel pattern 140A, and between the uppermost lower channel pattern 140A and the middle dielectric isolation structure MDI. The upper gate structure 160B may be located between the plurality of upper channel patterns 140B adjacent to each other in the third direction D3 and between the lowermost upper channel pattern 140B and the middle dielectric isolation structure MDI. The main gate structure 160M may be located on the uppermost upper channel pattern 140B.

The lower gate structure 160A may be adjacent to the lower source/drain pattern 300A. The upper gate structure 160B may be adjacent to the upper source/drain pattern 300B. The main gate structure 160M may be located on the lower gate structure 160A, the upper gate structure 160B, and the plurality of upper channel patterns 140B.

According to an embodiment, each of the lower gate structure 160A and the upper gate structure 160B may include a plurality of layers, and the plurality of layers may be stacked alternately with the plurality of channel patterns (channel layers) 140. For example, as shown in FIGS. 39 and 41, the lower gate structure 160A may include three (3) layers that are alternately stacked with the plurality of lower channel patterns 140A, and the upper gate structure 160B may include two (2) layers that may be alternately stacked with the plurality of upper channel patterns 140B. However, the present disclosure is not limited thereto, the number of layers of the lower gate structure 160A and the upper gate structure 160B may be changed in various ways.

Each of the lower gate structure 160A and the upper gate structure 160B may include gate electrodes 165A and 165B and gate insulating layers 162A and 162B.

The gate electrodes 165A and 165B may be located on the active pattern AP. For example, a lower gate electrode 165A may be located on the active pattern AP, and an upper gate electrode 165B may be located on the lower gate electrode 165A. The gate electrodes 165A and 165B may cross the active pattern AP. The gate electrodes 165A and 165B may surround the plurality of channel patterns 140. For example, the lower gate electrode 165A may surround the plurality of lower channel patterns 140A, and the upper gate electrode 165B may surround the plurality of upper channel patterns 140B.

In addition, at least a portion of the gate electrodes 165A and 165B may be located between the plurality of channel patterns 140. For example, the lower gate electrode 165A may be located between the plurality of lower channel patterns 140A, and the upper gate electrode 165B may be located between the plurality of upper channel patterns 140B. Another portion of the gate electrodes 165A and 165B may be located to cover both side surfaces of the stacking structure of the gate electrodes 165A and 165B and the plurality of channel patterns 140.

The gate electrodes 165A and 165B may include a conductive material. The gate electrodes 165A and 165B may include, but are not limited to, at least one of a metal, a metal alloy, a conductive metal nitride, a metal silicide, a doped semiconductor material, a conductive metal oxide, a conductive metal nitride oxide, or the like. The gate electrodes 165A and 165B may include, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), Zinc (Zn), vanadium (V), and a combination thereof, however, the present disclosure is not limited thereto. The conductive metal oxide and the conductive metal nitride oxide may include oxidized forms of the above-mentioned materials, however, the present disclosure is not limited thereto. The gate electrodes 165A and 165B may include the same material, however, the present disclosure is not limited thereto, and the gate electrodes 165A and 165B may include different materials.

The gate insulating layers 162A and 162B may be located along circumferences of the plurality of channel patterns 140. For example, a lower gate insulating layer 162A may be located along circumferences of the plurality of lower channel patterns 140A, and an upper gate insulating layer 162B may be located along circumferences of the plurality of upper channel patterns 140B. In addition, the lower gate insulating layer 162A may extend along the upper surface of the active pattern AP.

The lower gate insulating layer 162A may directly contact the active pattern AP, the plurality of lower channel patterns 140A, and the middle dielectric isolation structure MDI. The upper gate insulating layer 162B may directly contact the plurality of upper channel patterns 140B and the middle dielectric isolation structure MDI. The gate insulating layers 162A and 162B may be interposed between the plurality of channel patterns 140 and the gate electrodes 165A and 165B. The gate insulating layers 162A and 162B may include various insulating materials.

In an embodiment, the gate insulating layers 162A and 162B are shown as single layers, however, the present disclosure is not limited thereto. For example, the gate insulating layers 162A and 162B may be formed in a multilayer including a silicon oxide (SiOₓ) and high dielectric constant material. The high dielectric constant material may include a material having a higher dielectric constant than silicon oxide (SiOₓ) such as, but not limited to, hafnium oxide (HfO), aluminum oxide (AlO), or tantalum oxide (TaO).

The main gate structure 160M may be located on the upper gate structure 160B and the plurality of upper channel patterns 140B. The main gate structure 160M may be located on upper surfaces of the plurality of upper channel patterns 140B.

The main gate structure 160M may include a main gate electrode 165M and a main gate insulating layer 162M.

The main gate electrode 165M may be located on the upper gate structure 160B and the plurality of upper channel patterns 140B. The main gate electrode 165M may be located on the upper surfaces of the plurality of upper channel patterns 140B. Accordingly, four surfaces of the plurality of channel patterns 140 may be surrounded by the gate electrodes 165A and 165B and the main gate electrode 165M. The main gate electrode 165M may include a substantially similar and/or the same conductive material as the gate electrodes 165A and 165B. For example, the main gate electrode 165M may include at least one of a metal, a metal alloy, a conductive metal nitride, a metal silicide, a doped semiconductor material, a conductive metal oxide, and a conductive metal nitride oxide.

The main gate insulation layer 162M may extend along the side surface of the main gate electrode 165M. The main gate insulating layer 162M may extend along a side surface of a gate spacer 164. The main gate insulating layer 162M may include various insulating materials.

In an embodiment, the main gate insulating layer 162M is shown as a single layer, however, the present disclosure is not limited thereto. For example, the main gate insulating layer 162M may be formed in a multilayer including a silicon oxide (SiOₓ) and high dielectric constant material. The high dielectric constant material may include a material having a higher dielectric constant than silicon oxide (SiOₓ) such as, but not limited to, hafnium oxide (HfO), aluminum oxide (AlO), or tantalum oxide (TaO).

In an embodiment, the gate structure 160 may be electrically separated from adjacent gate structures by the gate separation pattern GC. That is, referring to FIGS. 38 and 41, a partial region of the main gate structure 160M may be penetrated in the third direction D3 by the gate separation pattern GC, and accordingly, the main gate structure 160M an may be electrically separated from adjacent gate structures in the second direction D2.

A semiconductor device, according to an embodiment, may further include a gate spacer 164 and a capping layer 166.

The gate spacer 164 may be located on a side surface of the main gate electrode 165M. The gate spacer 164 may not be located between the active pattern AP and the plurality of channel patterns 140. The gate spacer 164 may not be located between the plurality of channel patterns 140 adjacent in the third direction D3.

The gate spacer 164 may include, for example, at least one of silicon nitride (SiNₓ), silicon nitride oxide (SiON), silicon oxide (SiOₓ), silicon carbonate nitride (SiOCN), silicon boronnitride (SiBN), silicon oxyboronitride (SiOBN), silicon oxycarbide (SiOC), and a combination thereof. Although the gate spacer 164 is illustrated as a single layer, this is merely for the convenience of explanation, and the present disclosure is not limited thereto.

The capping layer 166 may be located on the main gate structure 160M and the gate spacer 164. An upper surface of the capping layer 166 may be located on the same plane as an upper surface of an interlayer insulation layer 107. In an embodiment, the capping layer 166 may also be located between the gate spacers 164.

The capping layer 166 may include, for example, at least one of silicon nitride (SiN), silicon nitride oxide (SiON), silicon (Si) carbonitride (SiCN), silicon carbonate nitride (SiOCN) and a combination thereof. The capping layer 166 may include a material having etch selectivity with respect to the interlayer insulation layer 107.

In an embodiment, the capping layer 166 and the gate spacer 164 may be penetrated in the third direction D3 along the gate separation pattern GC and the through electrode 190. The capping layer 166 may have an upper surface having a substantially similar and/or the same height as the upper surface of the gate separation pattern GC.

The source/drain patterns 300 may be located on at least the first side of the gate structure 160. For example, the source/drain patterns 300 may be located on both sides of the gate structure 160. The source/drain patterns 300 may be located on the active pattern AP. The source/drain patterns 300 may contact side surfaces of the plurality of channel patterns 140. The source/drain patterns 300 may be connected to the plurality of channel patterns 140.

The source/drain patterns 300, according to an embodiment, may include the lower source/drain pattern 300A and the upper source/drain pattern 300B. The lower source/drain pattern 300A may be located on the active pattern AP. The lower source/drain pattern 300A may be located on at least a first side of the lower gate structure 160A. For example, the lower source/drain pattern 300A may be located on both sides of the lower gate structure 160A. The lower source/drain pattern 300A may be connected to the plurality of lower channel patterns 140A.

The lower source/drain pattern 300A may be and/or may include epitaxial patterns formed by a selective epitaxial growth process using the active pattern AP and the plurality of lower channel patterns 140A as seeds. The lower source/drain pattern 300A may serve as a source/drain of the first transistor structure using the plurality of lower channel patterns 140A as channel regions. In an embodiment, the first transistor structure may be an N-type MOSFET, however, the present disclosure is not limited thereto.

As shown in FIG. 40, in the cross-section along the second direction D2 and the third direction D3, the lower source/drain pattern 300A may have a trapezoid shape of which the width is wider as it is closer to the upper surface of the base insulation layer 100. That is, in the cross-section along the second direction D2 and the third direction D3, the lower source/drain pattern 300A may include an inclined surface inclined from the upper surface of the base insulation layer 100. This may be due to the characteristics of the process in which the lower source/drain pattern 300A is formed in a space between the gate spacers 164 facing each other. However, the present disclosure is not limited thereto, and for example, widths of the lower source/drain pattern 300A along the second direction D2 may be constant.

In an embodiment, in the cross-section along the first direction D1 and the third direction D3, the lower source/drain pattern 300A may have an inclined side surface and may have a narrower lower width than an upper width along the second direction D2, according to the aspect ratio, however, the present disclosure is not limited thereto. For example, the lower width and the upper width of the lower source/drain pattern 300A along the second direction D2 may be substantially similar and/or the same.

In an embodiment, the lower source/drain pattern 300A is formed as a single layer, however, the present disclosure is not limited thereto, and the lower source/drain pattern 300A may be formed in a multilayer structure including a semiconductor material.

The upper source/drain pattern 300B of a semiconductor device, according to an embodiment, may be located on the lower source/drain pattern 300A.

The upper source/drain pattern 300B may be located to be spaced apart from the lower source/drain pattern 300A in the third direction D3. For example, the barrier structure 370 may be located between the upper source/drain pattern 300B and the lower source/drain pattern 300A, and the upper source/drain pattern 300B and the lower source/drain pattern 300A may be spaced apart by the barrier structure 370. Accordingly, the upper source/drain pattern 300B and the lower source/drain pattern 300A may be electrically insulated from each other.

The upper source/drain pattern 300B may be located on at least a first side of the upper gate structure 160B. For example, the upper source/drain pattern 300B may be located on both sides of the upper gate structure 160B. The upper source/drain pattern 300B may be connected to the plurality of upper channel patterns 140B.

The upper source/drain pattern 300B may contact side surfaces of the plurality of upper channel patterns 140B. In addition, unlike the lower source/drain pattern 300A, since the upper source/drain pattern 300B is located apart from the lower source/drain pattern 300A in the third direction D3, the upper source/drain pattern 300B may not contact the upper surface of the active pattern AP.

The upper source/drain pattern 300B may be epitaxial patterns formed by a selective epitaxial growth process using the plurality of upper channel patterns 140B as seeds. The upper source/drain pattern 300B may be a pattern formed by using both side surfaces of the plurality of upper channel patterns 140B as seeds. That is, unlike the lower source/drain pattern 300A being a pattern formed by using the upper surface of the active pattern AP and both side surfaces of the plurality of lower channel patterns 140A as seeds, the upper source/drain pattern 300B may be a pattern formed by using only both side surfaces of the plurality of upper channel patterns 140B as seeds. The upper source/drain pattern 300B may serve as a source/drain region of the second transistor structure using the plurality of upper channel patterns 140B as channel regions. In an embodiment, the second transistor structure may be a P-type MOSFET, however, the present disclosure is not limited thereto.

As shown in FIG. 40, in the cross-section along the second direction D2 and the third direction D3, the upper source/drain pattern 300B may have a different shape than the lower source/drain pattern 300A. For example, in the cross-section along the second direction D2 and the third direction D3, the upper source/drain pattern 300B may have a hexagonal shape, however, the present disclosure is not limited thereto. For example, the upper source/drain pattern 300B may have a circular shape, an elliptical shape, a pentagonal shape, or a shape similar thereto. In an embodiment, the lower source/drain pattern 300A may have a trapezoid shape of which the width is wider as it is closer to the upper surface of the base insulation layer 100. This may be due to characteristics of the process in which the upper source/drain pattern 300B is formed in a space open on the barrier structure 370 whereas the lower source/drain pattern 300A is formed in a space between the gate spacers 164 facing each other.

The gate separation pattern GC may extend in a direction (e.g., the first direction D1) crossing the gate structure 160. The gate separation pattern GC may also extend in the third direction D3. That is, the gate separation pattern GC may extend in the third direction D3, and penetrate the main gate structure 160M. Accordingly, the gate separation pattern GC may electrically separate gate structures 160 arranged in the first direction D1. The gate separation pattern GC may have an upper surface having a substantially similar and/or the same height as the capping layer 166 and/or a contact structure 380. The gate separation pattern GC may penetrate the main gate structure 160M in third direction, and extend into the active pattern AP. Referring to FIGS. 40 to 42, the lower surface of the gate separation pattern GC may contact the upper surface of the power rail PR. The gate separation pattern GC may include an insulating material. For example, the gate separation pattern GC may include silicon nitride (SiNₓ) and/or silicon oxide (SiOₓ). However, the present disclosure is not limited thereto, and the gate separation pattern GC may include various insulating materials for electrically separating the main gate structure 160M from other gate structures. In an embodiment, the gate separation pattern GC may be penetrated in the third direction D3 by the through electrode 190. That is, the gate separation pattern GC may surround the sidewall of the through electrode 190. Accordingly, the gate separation pattern GC may contact the sidewall of the through electrode 190. The air gap ag included in the gate separation pattern GC may be located between portions of both sidewalls of the through electrode 190 and the gate structure GS. The air gap ag included in the gate separation pattern GC may also be located between the interlayer insulation layer 107 and both sidewalls of the through electrode 190. The gate separation pattern GC may have an upper surface having a substantially similar and/or the same height as the upper surface of the through electrode 190. The gate separation pattern GC may have a lower surface having a substantially similar and/or the same height as the lower surface of the through electrode 190.

Referring to FIGS. 40 to 42, the gate separation pattern GC may include a plurality of insulation layers DP1 and DP2, and the air gap ag located between the insulation layers DP1 and DP2. For example, the gate separation pattern GC may include the first insulation pattern DP1, the second insulation pattern DP2, and the air gap ag located between the first insulation pattern DP1 and the second insulation pattern DP2.

The upper surface of the first insulation pattern DP1 may contact the interlayer insulation layer 107. The side surface of the first insulation pattern DP1 may contact the capping layer 166. The first insulation pattern DP1 may not be located in a region where the gate separation pattern GC is penetrated by the contact structure 380. Referring to FIG. 40, the first insulation pattern DP1 may have a lower surface located at a level higher than or equal to that of an upper surface of the upper source/drain pattern 300B. That is, the first insulation pattern DP1 may not overlap the upper source/drain pattern 300B and lower source/drain pattern 300A in the second direction D2. The first insulation pattern DP1 may include an insulating material. For example, the first insulation pattern DP1 may include at least one insulating material of silicon nitride (SiNₓ), silicon oxide (SiOₓ), and/or silicon carbonitride (SiCₓN_{y}). However, the present disclosure is not limited thereto, the first insulation pattern DP1 may include various insulating materials for electrically separating the main gate structure 160M from other gate structures. In an embodiment, the first insulation pattern DP1 may include an insulating material different from the insulating material included in the interlayer insulation layer 107. The first insulation pattern DP1 may include an insulating material having etch selectivity with respect to the interlayer insulation layer 107.

The lower surface of the second insulation pattern DP2 may contact the power rail PR. The side surface of the second insulation pattern DP2 may contact the field insulation layer 105. Referring to FIG. 40, the second insulation pattern DP2 may have an upper surface located at a level lower than or equal to that of a lower surface of the lower source/drain pattern 300A. That is, the second insulation pattern DP2 may not overlap the upper source/drain pattern 300B and lower source/drain pattern 300A in the second direction D2. However, the present disclosure is not limited thereto, the second insulation pattern DP2 may have an upper surface located at a level higher than the lower surface of the lower source/drain pattern 300A. The second insulation pattern DP2 may include an insulating material. For example, the second insulation pattern DP2 may include at least one insulating material of silicon nitride (SiNₓ), silicon oxide (SiOₓ), and/or silicon carbonitride (SiCₓN_{y}). However, the present disclosure is not limited thereto, and the second insulation pattern DP2 may include various insulating materials for electrically separating the main gate structure 160M from other gate structures. In an embodiment, the second insulation pattern DP2 may include the same insulating material as the insulating material included in the base insulation layer 100. In an embodiment, the second insulation pattern DP2 may be formed in the same process as the base insulation layer 100. However, the present disclosure is not limited thereto, and the second insulation pattern DP2 may be formed in a process separate from a process in which the base insulation layer 100 is formed. In such an embodiment, the second insulation pattern DP2 may include an insulating material different from the insulating material included in the base insulation layer 100.

The air gap ag may be located between the first insulation pattern DP1 and the second insulation pattern DP2. The air gap ag may refer to an empty space located between the first insulation pattern DP1 and the second insulation pattern DP2. Referring to FIG. 40, the air gap ag may include a portion that overlaps the upper source/drain pattern 300B and lower source/drain pattern 300A in the second direction D2. In an embodiment, the dielectric constant of the air gap ag may be lower than the dielectric constant of an insulating material included in the first insulation pattern DP1 and/or the second insulation pattern DP2. In an embodiment, the air gap ag may be filled with air, and the dielectric constant of air is about 1.

A semiconductor device, according to an embodiment, may further include the through electrode 190 penetrating the gate separation pattern GC, the contact structure 380 located between a source/drain pattern 300 and the through electrode 190, the interlayer insulation layer 107 covering the source/drain pattern 300, the gate structure 160, and the gate separation pattern GC, the lower wire structure 220 located on the lower surface of the base insulation layer 100, the power rail PR located on the lower wire structure 220.

The through electrode 190 may interconnect the contact structure 380 and the power rail PR. That is, a portion of the through electrode 190 may contact the contact structure 380, and another portion may contact the power rail PR. Referring to FIGS. 38 to 42, the through electrode 190, according to an embodiment, may be located on the interior of the gate separation pattern GC. That is, the through electrode 190 may be surround by the gate separation pattern GC. Accordingly, the contact structure 380 may penetrate a partial region of the gate separation pattern GC, and be connected to the through electrode 190. The width of the through electrode 190 in the second direction D2 may be narrower the closer it is to the power rail PR. The through electrode 190 may penetrate the gate separation pattern GC in the third direction D3. Accordingly, both sidewalls of the through electrode 190 may contact the gate separation pattern GC. The air gap ag may be located between the gate structure GS and portions of both sidewalls of the through electrode 190. The air gap ag may be located between a first interlayer insulation layer 107 and both sidewalls of the through electrode 190. The through electrode 190 may have an upper surface having a substantially similar and/or the same height as the gate separation pattern GC. The through electrode 190 may extend in the first direction D1 that is parallel to the gate separation pattern GC and the gate structure 160. The through electrode 190 may include a conductive material. For example, the through electrode 190 may include at least one of metal, metal alloy, conductive metal nitride, conductive metal carbide, conductive metal oxide, and conductive metal carbonitride. As the through electrode 190 is located inside the gate separation pattern GC, when manufacturing a semiconductor device according to an embodiment, the process margin may be improved, and the short circuit that may occur between the source/drain pattern 300 and the through electrode 190 may be prevented.

The contact structure 380 may be located on the upper source/drain pattern 300B. The contact structure 380 may penetrate the interlayer insulation layer 107 and be electrically connected to the upper source/drain pattern 300B. The contact structure 380 may have an inclined side surface having a narrower lower width than an upper width according to the aspect ratio, however, the present disclosure is not limited thereto. The contact structure 380 may be located to recess the upper source/drain pattern 300B by a predetermined depth. For example, a bottom surface of the contact structure 380 may be higher than a bottom surface of an uppermost channel pattern among the plurality of upper channel patterns 140B. However, the present disclosure is not limited thereto, and the bottom surface of the contact structure 380 may be located at a similar level with a bottom surface of the uppermost upper channel pattern 140B among the plurality of upper channel patterns 140B, or may be lower than the bottom surface of the uppermost upper channel pattern. Alternatively or additionally, the bottom surface of the contact structure 380 may be located between a bottom surface of the lowermost upper channel pattern among the plurality of upper channel patterns 140B and the bottom surface of the uppermost upper channel pattern. The contact structure 380 of the semiconductor device, according to an embodiment, may include a contact electrode 386, a first barrier layer 384 surrounding the contact electrode 386, and a first silicide layer 382 located between the first barrier layer 384 and the upper source/drain pattern 300B. The contact electrode 386 may include, for example, at least one of metal, metal alloy, conductive metal nitride, conductive metal carbide, conductive metal oxide, conductive metal carbonitride and 2-dimensional (2D) material. The first barrier layer 384 may include, for example, a metal nitride such as titanium nitride (TiN), tantalum nitride (TaN), or tungsten nitride (WN). The first silicide layer 382 may surround a portion of the contact electrode 386 recessed into the upper source/drain pattern 300B. The first silicide layer 382 may include metal-silicide. For example, the first silicide layer 382 may include at least one of titanium-silicide, tantalum-silicide, tungsten-silicide, nickel-silicide, and cobalt-silicide. In an embodiment, the number and arrangement form of conductive layers forming the contact structure 380 may be changed in various ways. In an embodiment, the first barrier layer 384 and/or the first silicide layer 382 may be omitted.

In an embodiment, the contact structure 380 may extend in the second direction D2, and be connected to the through electrode 190. That is, a portion of the contact structure 380 may contact the upper source/drain pattern 300B, and another portion may contact the through electrode 190. The contact structure 380 may have an upper surface having a substantially similar and/or the same height as the through electrode 190 and the gate separation pattern GC. Referring to FIGS. 38 and 40, the contact structure 380 may extend into the gate separation pattern GC. The contact structure 380 may penetrate a partial region of the gate separation pattern GC, and be connected to a portion of the through electrode 190.

The power rail PR may be located on the lower wire structure 220. The power rail PR may extend into the base insulation layer 100 along the third direction D3. That is, referring to FIGS. 40 and 41, the power rail PR may extend into the base insulation layer 100 along the third direction D3, and may contact the lower surface of the through electrode 190 and the gate separation pattern GC. The width of the power rail PR in the second direction D2 may be narrower the closer it is to the lower surface of the through electrode 190 and the gate separation pattern GC. Referring to FIG. 42, the power rail PR may also extend in the first direction D1. The lower surface of the power rail PR may contact the lower wire structure 220. The power rail PR may include a conductive material. For example, the power rail PR may include at least one of metal, metal alloy, conductive metal nitride, conductive metal carbide, conductive metal oxide, and conductive metal carbonitride. The power rail PR may be connected to the lower wire structure 220, and transfer the electric power supplied from the lower wire structure 220 to the source/drain pattern 300.

The lower wire structure 220 may be disposed on the bottom surface of the base insulation layer 100. In an embodiment, the lower wire structure 220 may be a configuration to supply electric power to the source/drain pattern 300. For example, the lower wire structure 220 may be a power delivery network. The lower wire structure 220 may include lower wires 221, a lower via or vias 222 and a lower insulation layer 223. The lower wires 221 and the lower vias 222 may be located on the bottom surface of the base insulation layer 100. The lower wires 221 and the lower vias 222 may include a metal (e.g., copper (Cu)). The lower insulation layer 223 may be located on the bottom surface of the base insulation layer 100. The lower insulation layer 223 may be disposed between the bottom surface of the base insulation layer 100, the lower wires 221 and the lower vias 222 and insulate them. That is, the lower insulation layer 223 may cover the lower wires 221 and the bottom surface of the base insulation layer 100. A lower wire 221 and the lower vias 222 may be located within the lower insulation layer 223. The lower insulation layer 223 may include, for example, at least one of silicon oxide (SiOₓ), silicon nitride (SiNₓ), silicon nitride oxide (SiON), or low dielectric layers.

The barrier structure 370 may be located between the lower source/drain pattern 300A and the upper source/drain pattern 300B. The barrier structure 370 may overlap the lower source/drain pattern 300A and the upper source/drain pattern 300B in third direction D3. The barrier structure 370 may be located between the middle dielectric isolation structure MDI (between two neighboring portions of the middle dielectric isolation structure MDI). Upper surface and bottom surface of the barrier structure 370 may be flat, however, the present disclosure is not limited thereto. For example, an upper surface and/or a bottom surface of the barrier structure 370 may have a shape that is concave or convex in the third direction D3.

The barrier structure 370 may include a first barrier pattern 371 extending along a side surface of the middle dielectric isolation structure MDI and an upper surface of the lower source/drain pattern 300A and a second barrier pattern 372 located on the first barrier pattern 371. The first barrier pattern 371 may be located on a side surface of the gate spacer 164, however, the present disclosure is not limited thereto. For example, the first barrier pattern 371 may not be located on the side surface of the gate spacer 164.

First and second barrier patterns 371 and 372 may include various insulating materials. The first barrier pattern 371 and the second barrier pattern 372 may include different materials, however, the present disclosure is not limited thereto. For example, the first barrier pattern 371 may include silicon nitride (SiN), silicon nitride oxide (SiON), or a combination thereof, and the second barrier pattern 372 may include silicon oxide (SiO), silicon nitride (SiN), silicon nitride oxide (SiON), or a combination thereof. The barrier structure 370 may space the lower source/drain pattern 300A and the upper source/drain pattern 300B apart from each other in the third direction D3.

A semiconductor device, according to an embodiment, may further include the interlayer insulation layer 107.

The interlayer insulation layer 107 may be located on the side surface of the gate spacer 164, a side surface of the capping layer 166, and the upper surface of the upper source/drain pattern 300B. The interlayer insulation layer 107 may not cover the upper surface of the capping layer 166.

The interlayer insulation layer 107 may include, for example, at least one of silicon oxide (SiOₓ), silicon nitride (SiNₓ), silicon nitride oxide (SiON), and a low dielectric constant material. A low dielectric constant material may include, for example, Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), Tonen SilaZen (TOSZ), fluoride silicate glass (FSG), polyimide nanofoams such as polypropylene oxide, carbon doped silicon oxide (CDO), Organo silicate glass (OSG), SiLK, Amorphous Fluorinated Carbon, silica aerogels, silica xerogels, mesoporous silica or a combination thereof, however, the present disclosure is not limited thereto.

## Claims

1. A semiconductor device, comprising:
a base insulation layer (100) comprising a first surface and a second surface facing the first surface;
a channel layer (110a-110d; 140) on the first surface of the base insulation layer (100);
source/drain patterns (150; 300) disposed in a first direction (D1) parallel to the first surface of the base insulation layer (100) interposing the channel layer (110a-110d; 140);
a gate structure (GS; 160) extending in a second direction (D2) crossing the first direction (D1) on the first surface of the base insulation layer (100) and at least partially surrounding the channel layer (110a-110d; 140);
a gate separation pattern (GC) crossing the gate structure (GS; 160) and at least partially penetrating the gate structure (GS; 160) in a third direction (D3) perpendicular to the first direction (D1) and the second direction (D2); and
a through electrode (190) at least partially penetrating the gate separation pattern (GC) in the third direction (D3),
wherein the gate structure (GS; 160) comprises a first gate structure disposed on a first side of the gate separation pattern (GC) and a second gate structure disposed on a second side of the gate separation pattern (GC), and
wherein the gate separation pattern (GC) comprises an air gap (ag) disposed between the first gate structure and the through electrode (190) and between the second gate structure and the through electrode (190).

2. The semiconductor device of claim 1, further comprising:
a lower wire structure (220) on the second surface of the base insulation layer (100); and
a power rail (PR) on the lower wire structure (220) and at least partially penetrating the base insulation layer (100) in the third direction (D3),
wherein the through electrode (190) comprises a first end coupled to the power rail (PR).

3. The semiconductor device of claim 1 or 2, wherein the gate separation pattern (GC) further comprises a first insulation pattern (DP1) disposed on the air gap (ag) and a second insulation pattern (DP2) disposed between the air gap (ag) and a power rail (PR),
wherein the first insulation pattern (DP1) comprises a first insulating material, and
wherein the second insulation pattern (DP2) comprises a second insulating material different from the first insulating material.

4. The semiconductor device of claim 3, wherein a level of a lower surface of the first insulation pattern (DP1) is higher than or equal to a level of an upper surface of the source/drain patterns (150; 300), and
wherein the level of the lower surface of the first insulation pattern (DP1) is lower than a level of an upper surface of the gate structure (GS; 160).

5. The semiconductor device of claim 3 or 4, wherein a level of an upper surface of the second insulation pattern (DP2) is lower than or equal to a level of a lower surface of the source/drain patterns (150; 300).

6. The semiconductor device of claim 3, wherein a level of a lower surface of the first insulation pattern (DP1) is lower than or equal to a level of an upper surface of the source/drain patterns (150; 300), and
wherein the first level of the lower surface of the first insulation pattern (DP1) is higher than a level of a lower surface of the source/drain patterns (150; 300).

7. The semiconductor device of any one of claims 3 to 6, further comprising:
a contact electrode (180) disposed between an upper surface of the source/drain patterns (150) and the through electrode (190), extending into the gate separation pattern (GC), and comprising a first end in contact with a portion of the through electrode (190); and
a metal pattern (MP) comprising an upper surface in contact with a lower surface of the contact electrode (180) and a lower surface in contact with the air gap (ag).

8. The semiconductor device of claim 7, wherein a level of a lower surface of the first insulation pattern (DP1) is higher than a level of the upper surface of the metal pattern (MP).

9. A method of manufacturing a semiconductor device, comprising:
forming, on a first surface of a substrate (10), a channel layer (110a-110d; 140) and source/drain patterns (150; 300) disposed in a first direction (D1) parallel to the first surface of the substrate (10) interposing the channel layer (110a-110d; 140);
forming a gate structure (GS; 160) extending in a second direction (D2) crossing the first direction (D1) and at least partially surrounding the channel layer (110a-110d; 140) in the second direction (D2);
forming a gate separation pattern (GC) crossing the gate structure (GS; 160) and at least partially penetrating the gate structure (GS; 160) in a third direction (D3) perpendicular to the first direction (D1) and the second direction (D2);
forming a through electrode (190) at least partially penetrating the gate separation pattern (GC) in the third direction (D3); and
forming an air gap (ag) between the gate structure (GS; 160) and a first sidewall and a second sidewall of the through electrode (190) within the gate separation pattern (GC).

10. The method of claim 9, wherein the forming of the gate separation pattern (GC) comprises:
forming a first insulation pattern (DP1) by etching a portion of the gate structure and filling the etched portion with an insulating material, and
wherein the forming of the through electrode (190) comprises:
forming a first trench (TR1) exposing the upper surface of the substrate by etching a portion of the first insulation pattern (DP1); and
filling an interior of the first trench (TR1) with a conductive material.

11. The method of claim 10, wherein the forming of the air gap (ag) comprises:
exposing a lower surface of the first insulation pattern (DP1) and a lower surface of the through electrode (190) by etching a bottom surface of the substrate (10);
forming a second trench (TR2) inside the first insulation pattern (DP1) by etching the first insulation pattern (DP1); and
forming a base insulation layer (100) at least partially covering the lower surface of the through electrode (190) and the second trench (TR2), in a region where the substrate (10) is removed.

12. The method of claim 11, further comprising:
forming a power rail (PR) at least partially penetrating the base insulation layer (100) in the third direction (D3) and comprising an upper surface in contact with the lower surface of the through electrode (190),
wherein the gate separation pattern (GC) further comprises a second insulation pattern (DP2) located between the air gap (ag) and the power rail (PR), and
wherein the second insulation pattern (DP2) is formed as a portion of the base insulation layer (100) at least partially overlapping the third trench (TR2) in the third direction (D3) protrudes into the third trench (TR2).

13. The method of claim 12, wherein a level of the lower surface of the first insulation pattern (DP1) is higher than or equal to a level of an upper surface of the source/drain patterns (150; 300), and
wherein the level of the lower surface of the first insulation pattern (DP1) is lower than a level of an upper surface of the gate structure (GS; 160).

14. The method of claim 12 or 13, wherein a level of an upper surface of the second insulation pattern (DP2) is lower than a level of a lower surface of the source/drain patterns (150; 300).

15. The method of claim 12, wherein a level of the lower surface of the first insulation pattern (DP1) is lower than or equal to a level of an upper surface of the source/drain patterns (150; 300), and
wherein the level of the lower surface of the first insulation pattern (DP1) is higher than a level of a lower surface of the source/drain patterns (150; 300).

## Patentansprüche

1. Halbleiterbauelement, aufweisend:
eine Basisisolationsschicht (100), die eine erste Oberfläche und eine der ersten Oberfläche gegenüberliegende zweite Oberfläche aufweist;
eine Kanalschicht (110a-110d; 140) auf der ersten Oberfläche der Basisisolationsschicht (100);
Source-/Drain-Muster (150; 300), die in einer ersten Richtung (D1) parallel zu der ersten Oberfläche der Basisisolationsschicht (100) angeordnet sind, wobei die Kanalschicht (110a-110d; 140) dazwischen angeordnet ist;
eine Gate-Struktur (GS; 160), die sich in einer zweiten Richtung (D2), die die erste Richtung (D1) kreuzt, auf der ersten Oberfläche der Basisisolationsschicht (100) erstreckt und die Kanalschicht (110a-110d; 140) zumindest teilweise umgibt;
ein Gate-Trennmuster (GC), das die Gate-Struktur (GS; 160) kreuzt und die Gate-Struktur (GS; 160) in einer dritten Richtung (D3) senkrecht zu der ersten Richtung (D1) und der zweiten Richtung (D2) zumindest teilweise durchdringt; und
eine Durchgangselektrode (190), die das Gate-Trennmuster (GC) in der dritten Richtung (D3) zumindest teilweise durchdringt,
wobei die Gate-Struktur (GS; 160) eine erste Gate-Struktur, die auf einer ersten Seite des Gate-Trennmusters (GC) angeordnet ist, und eine zweite Gate-Struktur aufweist, die auf einer zweiten Seite des Gate-Trennmusters (GC) angeordnet ist, und
wobei das Gate-Trennmuster (GC) einen Luftspalt (ag) aufweist, der zwischen der ersten Gate-Struktur und der Durchgangselektrode (190) sowie zwischen der zweiten Gate-Struktur und der Durchgangselektrode (190) angeordnet ist.

2. Halbleiterbauelement nach Anspruch 1, ferner aufweisend:
eine untere Drahtstruktur (220) auf der zweiten Oberfläche der Basisisolationsschicht (100); und
eine Leistungsschiene (PR) auf der unteren Drahtstruktur (220), die die Basisisolationsschicht (100) in der dritten Richtung (D3) zumindest teilweise durchdringt,
wobei die Durchgangselektrode (190) ein erstes Ende aufweist, das mit der Leistungsschiene (PR) verbunden ist.

3. Halbleiterbauelement nach Anspruch 1 oder 2, wobei das Gate-Trennmuster (GC) ferner ein erstes Isolationsmuster (DP1), das auf dem Luftspalt (ag) angeordnet ist, und ein zweites Isolationsmuster (DP2), das zwischen dem Luftspalt (ag) und einer Leistungsschiene (PR) angeordnet ist, aufweist,
wobei das erste Isolationsmuster (DP1) ein erstes Isoliermaterial aufweist, und
wobei das zweite Isolationsmuster (DP2) ein zweites Isoliermaterial aufweist, das sich von dem ersten Isoliermaterial unterscheidet.

4. Halbleiterbauelement nach Anspruch 3, wobei eine Ebene einer unteren Oberfläche des ersten Isolationsmusters (DP1) höher als oder gleich einer Ebene einer oberen Oberfläche der Source-/Drain-Muster (150; 300) ist, und
wobei die Ebene der unteren Oberfläche des ersten Isolationsmusters (DP1) niedriger ist als eine Ebene einer oberen Oberfläche der Gate-Struktur (GS; 160).

5. Halbleiterbauelement nach Anspruch 3 oder 4, wobei eine Ebene einer oberen Oberfläche des zweiten Isolationsmusters (DP2) niedriger als oder gleich einer Ebene einer unteren Oberfläche der Source-/Drain-Muster (150; 300) ist.

6. Halbleiterbauelement nach Anspruch 3, wobei eine Ebene einer unteren Oberfläche des ersten Isolationsmusters (DP1) niedriger als oder gleich einer Ebene einer oberen Oberfläche der Source-/Drain-Muster (150; 300) ist, und
wobei die erste Ebene der unteren Oberfläche des ersten Isolationsmusters (DP1) höher ist als eine Ebene einer unteren Oberfläche der Source-/Drain-Muster (150; 300).

7. Halbleiterbauelement nach einem der Ansprüche 3 bis 6, ferner aufweisend:
eine Kontaktelektrode (180), die zwischen einer oberen Oberfläche der Source-/Drain-Muster (150) und der Durchgangselektrode (190) angeordnet ist, sich in das Gate-Trennmuster (GC) erstreckt und ein erstes Ende aufweist, das mit einem Abschnitt der Durchgangselektrode (190) in Kontakt steht; und
ein Metallmuster (MP), das eine obere Oberfläche, die mit einer unteren Oberfläche der Kontaktelektrode (180) in Kontakt steht, und eine untere Oberfläche aufweist, die mit dem Luftspalt (ag) in Kontakt steht.

8. Halbleiterbauelement nach Anspruch 7, wobei eine Ebene einer unteren Oberfläche des ersten Isolationsmusters (DP1) höher ist als eine Ebene der oberen Oberfläche des Metallmusters (MP).

9. Verfahren zur Herstellung eines Halbleiterbauelements, umfassend:
Ausbilden einer Kanalschicht (110a-110d; 140) und von Source-/Drain-Mustern (150; 300) auf einer ersten Oberfläche eines Substrats (10), wobei die Source-/Drain-Muster in einer ersten Richtung (D1) parallel zur ersten Oberfläche des Substrats (10) angeordnet sind und die Kanalschicht (110a-110d; 140) dazwischen angeordnet ist;
Ausbilden einer Gate-Struktur (GS; 160), die sich in einer zweiten Richtung (D2) erstreckt, die die erste Richtung (D1) kreuzt, und die die Kanalschicht (110a-110d; 140) in der zweiten Richtung (D2) zumindest teilweise umgibt;
Ausbilden eines Gate-Trennmusters (GC), das die Gate-Struktur (GS; 160) kreuzt und die Gate-Struktur (GS; 160) in einer dritten Richtung (D3) senkrecht zu der ersten Richtung (D1) und der zweiten Richtung (D2) zumindest teilweise durchdringt;
Ausbilden einer Durchgangselektrode (190), die das Gate-Trennmuster (GC) in der dritten Richtung (D3) zumindest teilweise durchdringt; und
Ausbilden eines Luftspalts (ag) zwischen der Gate-Struktur (GS; 160) und einer ersten Seitenwand sowie einer zweiten Seitenwand der Durchgangselektrode (190) innerhalb des Gate-Trennmusters (GC).

10. Verfahren nach Anspruch 9, wobei das Ausbilden des Gate-Trennmusters (GC) umfasst:
Ausbilden eines ersten Isolationsmusters (DP1) durch Ätzen eines Abschnitts der Gate-Struktur und Befüllen des geätzten Abschnitts mit einem isolierenden Material, und wobei das Ausbilden der Durchgangselektrode (190) umfasst:
Ausbilden eines ersten Grabens (TR1), der die obere Oberfläche des Substrats freilegt, durch Ätzen eines Abschnitts des ersten Isolationsmusters (DP1); und
Befüllen eines Inneren des ersten Grabens (TR1) mit einem leitfähigen Material.

11. Verfahren nach Anspruch 10, wobei das Ausbilden des Luftspalts (ag) aufweist:
Freilegen einer unteren Oberfläche des ersten Isolationsmusters (DP1) und einer unteren Oberfläche der Durchgangselektrode (190) durch Ätzen einer Bodenoberfläche des Substrats (10);
Ausbilden eines zweiten Grabens (TR2) innerhalb des ersten Isolationsmusters (DP1) durch Ätzen des ersten Isolationsmusters (DP1); und
Ausbilden einer Basisisolationsschicht (100), die die untere Oberfläche der Durchgangselektrode (190) und den zweiten Graben (TR2) zumindest teilweise bedeckt, in einem Bereich, in dem das Substrat (10) entfernt worden ist.

12. Verfahren nach Anspruch 11, ferner umfassend:
Ausbilden einer Leistungsschiene (PR), die die Basisisolationsschicht (100) in der dritten Richtung (D3) zumindest teilweise durchdringt und eine obere Oberfläche aufweist, die mit der unteren Oberfläche der Durchgangselektrode (190) in Kontakt steht,
wobei das Gate-Trennmuster (GC) ferner ein zweites Isolationsmuster (DP2) aufweist, das zwischen dem Luftspalt (ag) und der Leistungsschiene (PR) angeordnet ist, und
wobei das zweite Isolationsmuster (DP2) als ein Abschnitt der Basisisolationsschicht (100) ausgebildet ist, der den dritten Graben (TR2) in der dritten Richtung (D3) zumindest teilweise überlappt und in den dritten Graben (TR2) hineinragt.

13. Verfahren nach Anspruch 12, wobei eine Ebene der unteren Oberfläche des ersten Isolationsmusters (DP1) höher als oder gleich einer Ebene einer oberen Oberfläche der Source-/Drain-Muster (150; 300) ist, und
wobei die Ebene der unteren Oberfläche des ersten Isolationsmusters (DP1) niedriger als eine Ebene einer oberen Oberfläche der Gate-Struktur (GS; 160) ist.

14. Verfahren nach Anspruch 12 oder 13, wobei eine Ebene einer oberen Oberfläche des zweiten Isolationsmusters (DP2) niedriger ist als eine Ebene einer unteren Oberfläche der Source-/Drain-Muster (150; 300).

15. Verfahren nach Anspruch 12, wobei eine Ebene der unteren Oberfläche des ersten Isolationsmusters (DP1) niedriger als oder gleich der Ebene einer oberen Oberfläche der Source-/Drain-Muster (150; 300) ist, und
wobei die Ebene der unteren Oberfläche des ersten Isolationsmusters (DP1) höher ist als eine Ebene einer unteren Oberfläche der Source-/Drain-Muster(150; 300).

## Revendications

1. Dispositif à semi-conducteur, comprenant :
une couche isolante de base (100) comprenant une première surface et une deuxième surface tournée vers la première surface ;
une couche de canal (110a-110d ; 140) disposée sur la première surface de la couche isolante de base (100) ;
des motifs de source/drain (150 ; 300) disposés dans une première direction (D1) parallèle à la première surface de la couche isolante de base (100) et intercalant la couche de canal (110a-110d ; 140) ;
une structure de grille (GS ; 160) s'étendant dans une deuxième direction (D2) croisant la première direction (D1) sur la première surface de la couche isolante de base (100) et entourant au moins partiellement la couche de canal (110a-110d ; 140) ;
un motif de séparation de grille (GC) traversant la structure de grille (GS ; 160) et pénétrant au moins partiellement dans la structure de grille (GS ; 160) dans une troisième direction (D3) perpendiculaire à la première direction (D1) et à la deuxième direction (D2) ; et
une électrode traversante (190) pénétrant au moins partiellement dans le motif de séparation de grille (GC) dans la troisième direction (D3),
dans lequel la structure de grille (GS ; 160) comprend une première structure de grille disposée sur un premier côté du motif de séparation de grille (GC) et une deuxième structure de grille disposée sur un deuxième côté du motif de séparation de grille (GC), et
dans lequel le motif de séparation de grille (GC) comprend un entrefer (ag) disposé entre la première structure de grille et l'électrode traversante (190) et entre la deuxième structure de grille et l'électrode traversante (190).

2. Dispositif à semi-conducteur selon la revendication 1, comprenant en outre :
une structure de câblage inférieure (220) sur la deuxième surface de la couche isolante de base (100) ; et
un rail d'alimentation (PR) sur la structure de câblage inférieure (220) et pénétrant au moins partiellement dans la couche isolante de base (100) dans la troisième direction (D3),
dans lequel l'électrode traversante (190) comprend une première extrémité couplée au rail d'alimentation (PR).

3. Dispositif à semi-conducteur selon la revendication 1 ou 2, dans lequel le motif de séparation de grille (GC) comprend en outre un premier motif isolant (DP1) disposé sur l'entrefer (ag) et un deuxième motif isolant (DP2) disposé entre l'entrefer (ag) et un rail d'alimentation (PR),
dans lequel le premier motif isolant (DP1) comprend un premier matériau isolant, et
dans lequel le deuxième motif isolant (DP2) comprend un deuxième matériau isolant différent du premier matériau isolant.

4. Dispositif à semi-conducteur selon la revendication 3, dans lequel un niveau d'une surface inférieure du premier motif isolant (DP1) est supérieur ou égal au niveau d'une surface supérieure des motifs de source/drain (150 ; 300), et
dans lequel le niveau de la surface inférieure du premier motif isolant (DP1) est inférieur au niveau d'une surface supérieure de la structure de grille (GS ; 160).

5. Dispositif à semi-conducteur selon la revendication 3 ou 4, dans lequel un niveau de la surface supérieure du deuxième motif isolant (DP2) est inférieur ou égal au niveau de la surface inférieure des motifs de source/drain (150 ; 300).

6. Dispositif à semi-conducteur selon la revendication 3, dans lequel un niveau de la surface inférieure du premier motif isolant (DP1) est inférieur ou égal au niveau de la surface supérieure des motifs de source/drain (150 ; 300), et
dans lequel le premier niveau de la surface inférieure du premier motif isolant (DP1) est supérieur au niveau de la surface inférieure des motifs de source/drain (150 ; 300).

7. Dispositif à semi-conducteur selon l'une quelconque des revendications 3 à 6, comprenant en outre :
une électrode de contact (180) disposée entre une surface supérieure des motifs de source/drain (150) et l'électrode traversante (190), s'étendant dans le motif de séparation de grille (GC), et comprenant une première extrémité en contact avec une partie de l'électrode traversante (190) ; et
un motif métallique (MP) comprenant une surface supérieure en contact avec une surface inférieure de l'électrode de contact (180) et une surface inférieure en contact avec l'entrefer (ag).

8. Dispositif à semi-conducteur selon la revendication 7, dans lequel le niveau d'une surface inférieure du premier motif isolant (DP1) est supérieur au niveau de la surface supérieure du motif métallique (MP).

9. Procédé de fabrication d'un dispositif à semi-conducteur, comprenant :
former, sur une première surface d'un substrat (10), une couche de canal (110a-110d ; 140) et des motifs de source/drain (150 ; 300) disposés dans une première direction (D1) parallèle à la première surface du substrat (10) et intercalant la couche de canal (110a-110d ; 140) ;
former une structure de grille (GS ; 160) s'étendant dans une deuxième direction (D2) traversant la première direction (D1) et entourant au moins partiellement la couche de canal (110a-110d ; 140) dans la deuxième direction (D2) ;
former un motif de séparation de grille (GC) traversant la structure de grille (GS ; 160) et pénétrant au moins partiellement dans la structure de grille (GS ; 160) dans une troisième direction (D3) perpendiculaire à la première direction (D1) et à la deuxième direction (D2) ;
former une électrode traversante (190) pénétrant au moins partiellement dans le motif de séparation de grille (GC) dans la troisième direction (D3) ; et
former un entrefer (ag) entre la structure de grille (GS ; 160) et une première paroi latérale et une deuxième paroi latérale de l'électrode traversante (190) à l'intérieur du motif de séparation de grille (GC).

10. Procédé selon la revendication 9, dans lequel la formation du motif de séparation de grille (GC) comprend :
former un premier motif isolant (DP1) par gravure d'une partie de la structure de grille et par le remplissage de la partie gravée avec un matériau isolant, et
dans lequel la formation de l'électrode traversante (190) comprend :
former une première tranchée (TR1) exposant la surface supérieure du substrat par gravure d'une partie du premier motif isolant (DP1) ; et
remplir un intérieur de la première tranchée (TR1) avec un matériau conducteur.

11. Procédé selon la revendication 10, dans lequel la formation de l'entrefer (ag) comprend :
exposer une surface inférieure du premier motif isolant (DP1) et une surface inférieure de l'électrode traversante (190) par gravure d'une face arrière inférieure du substrat (10) ;
former une deuxième tranchée (TR2) à l'intérieur du premier motif isolant (DP1) par gravure du premier motif isolant (DP1) ; et
former une couche isolante de base (100) recouvrant au moins partiellement la surface inférieure de l'électrode traversante (190) et la deuxième tranchée (TR2), dans une région où le substrat (10) a été retiré.

12. Procédé selon la revendication 11, comprenant en outre :
former un rail d'alimentation (PR) pénétrant au moins partiellement dans la couche isolante de base (100) dans la troisième direction (D3) et comportant une surface supérieure en contact avec la surface inférieure de l'électrode traversante (190),
dans lequel le motif de séparation de grille (GC) comprend en outre un deuxième motif isolant (DP2) situé entre l'entrefer (ag) et le rail d'alimentation (PR), et
dans lequel le deuxième motif isolant (DP2) est formé en tant que partie de la couche isolante de base (100) chevauchant au moins partiellement la troisième tranchée (TR2) dans la troisième direction (D3) et faisant saillie dans la troisième tranchée (TR2).

13. Procédé selon la revendication 12, dans lequel un niveau de la surface inférieure du premier motif isolant (DP1) est supérieur ou égal au niveau de la surface supérieure des motifs de source/drain (150 ; 300), et
dans lequel le niveau de la surface inférieure du premier motif isolant (DP1) est inférieur au niveau de la surface supérieure de la structure de grille (GS ; 160).

14. Procédé selon la revendication 12 ou 13, dans lequel le niveau de la surface supérieure du deuxième motif isolant (DP2) est inférieur au niveau de la surface inférieure des motifs de source/drain (150 ; 300).

15. Procédé selon la revendication 12, dans lequel le niveau de la surface inférieure du premier motif isolant (DP1) est inférieur ou égal au niveau de la surface supérieure des motifs de source/drain (150 ; 300), et
dans lequel le niveau de la surface inférieure du premier motif isolant (DP1) est supérieur au niveau de la surface inférieure des motifs de source/drain (150 ; 300).
